# EUROPEAN PATENT SPECIFICATION

(11) **EP 4 601 436 B1**
(45) Date of publication and mention of the grant of the patent: **01.07.2026**
(21) Application number: 24169782.0
(22) Date of filing: 11.04.2024
(51) Int. Cl.: H10F 77/00, H10F 10/14

(54) **SOLAR CELL AND PHOTOVOLTAIC MODULE**
SOLARZELLE UND FOTOVOLTAISCHES MODUL
CELLULE SOLAIRE ET MODULE PHOTOVOLTAÏQUE

(30) Priority: 07.02.2024 CN 202410175610; 07.02.2024 CN 202410175823; 07.02.2024 CN 202410175826
(43) Date of publication of application: 13.08.2025
(73) Proprietor: Jinko Solar (Haining) Co., Ltd., Haining City, Zhejiang 314415 (CN)
(72) Inventor: TAO, Wusong, Haining City, Zhejiang (CN); WANG, Luchuang, Haining City, Zhejiang (CN); QIN, Niannian, Haining City, Zhejiang (CN); YANG, Jingguo, Haining City, Zhejiang (CN); ZHAO, Zijie, Haining City, Zhejiang (CN); XU, Zhaofang, Haining City, Zhejiang (CN); GUO, Zhiqiu, Haining City, Zhejiang (CN); WANG, Wei, Haining City, Zhejiang (CN); XIA, Zhipeng, Haining City, Zhejiang (CN); HUANG, Jide, Haining City, Zhejiang (CN); LIU, Changming, Haining City, Zhejiang (CN); ZHANG, Xinyu, Haining City, Zhejiang (CN); JIN, Hao, Haining City, Zhejiang (CN)
(74) Representative: Balder IP Law, S.L.

(56) References cited:
- WO-A1-2023/024585
- AU-A1- 2023 286 031
- CN-A- 115 148 839
- CN-A- 117 219 687
- CN-U- 218 677 162

## Description

### TECHNICAL FIELD

The various embodiments described in this document relate in general to the technical field of photovoltaic, and more specifically to a solar cell and a photovoltaic module.

### BACKGROUND

There are two main factors affecting photoelectric conversion efficiency and yield of solar cells, including: optical loss and electrical loss. The optical loss includes shielding loss, carrier recombination loss of the substrate, carrier recombination loss of highly doped films, and refraction loss of film. The electrical loss includes resistance loss of materials, contact loss of electrodes, and contact loss and pseudo soldering between ribbons and solar cells.

Therefore, a solar cell and a photovoltaic module that can reduce electrical loss and optical loss need to be provided, thereby improving the photoelectric conversion efficiency of the solar cells and the yield of the photovoltaic module.

CN218677162U discloses a solar cell string and a photovoltaic module, the solar cell string includes at least two IBC cells and conductive interconnection strips, the backside of the IBC cell is provided with a positive electrode, a negative electrode, and pole equipotential lines (including positive pole equipotential lines and/or negative pole equipotential lines), the positive pole equipotential lines are connected to the positive electrode, and the negative pole equipotential lines are connected to the negative electrode; the positive pole equipotential lines and the negative pole equipotential lines of the adjacent IBC cells are connected through conductive interconnection strips, and the conductive interconnection strips cover the back surfaces of the IBC cells.

### SUMMARY

The invention is set out in the appended set of claims.

In some embodiments, the respective edge electrode has a polarity same as a polarity of an adjacent finger electrode, wherein there is no other finger electrode between the respective edge electrode and the adjacent finger electrode.

In some embodiments, the first edge electrode is electrically connected with the n₁ first main busbars, and the second edge electrode is electrically connected with the n₂ second main busbars, wherein 1 < n₁ < m₁, and 1 < n₂ < m₂.

In some embodiments, a respective row of first finger electrodes includes first sub-electrodes spaced by first spacer regions in the first direction such that each pair of adjacent first sub-electrodes in the respective row of first finger electrodes are separated by a corresponding first spacer region of the first spacer regions, a respective second main busbar is disposed on a corresponding first spacer region, and a respective first main busbar is electrically connected with a corresponding first sub-electrode of each row of first finger electrodes; and a respective row of second finger electrodes includes second sub-electrodes spaced by second spacer regions in the first direction such that each pair of adjacent second sub-electrodes in the respective row of second finger electrodes are separated by a corresponding second spacer region of the second spacer regions, a respective first main busbar is disposed on a corresponding second spacer region, and a respective second main busbar is electrically connected with a corresponding second sub-electrode of each row of second finger electrodes.

In some embodiments, the respective edge electrode has a width in the second direction greater than or equal to a width of a respective finger electrode in the second direction.

In some embodiments, the respective edge electrode has a width in the second direction ranging from: 10µm to 55µm.

In some embodiments, the respective edge electrode is spaced from an adjacent finger electrode by a first pitch, and the first pitch is less than or equal to a distance between a respective first finger electrode and an adjacent second finger electrode.

In some embodiments, the first pitch ranges from 0.2 mm to 0.7 mm.

In some embodiments, the distance between the respective first finger electrode and the adjacent second finger electrode ranges from 0.3 mm to 0.8 mm.

In some embodiments, the respective edge electrode and a respective finger electrode include a same material.

In some embodiments, the first edge electrode is between one first boundary and a second finger electrode, and the second edge electrode is between another first boundary and a first finger electrode.

In some embodiments, the solar cell includes at least one first connection electrode penetrating the passivation layer to be electrically connected with the substrate, where the at least one first connection electrode is electrically connected with remaining m₁-n₁ first main busbars.

In some embodiments, the solar cell includes at least one second connection electrode penetrating the passivation layer to be electrically connected with the substrate, where the at least one second connection electrode is electrically connected with remaining m₂-n₂ of the second main busbars.

In some embodiments, the at least one first connection electrode includes a material same as a material of the finger electrodes, and the at least one second connection electrode includes a material same as a material of the finger electrodes.

In some embodiments, a respective first connection electrode has a width greater than or equal to a width of a respective finger electrode in the second direction, and a respective second connection electrode has a width greater than or equal to the width of the respective finger electrode in the second direction.

According to another aspect, some embodiments of the disclosure provide a photovoltaic module, including: at least one cell string each formed by connecting a plurality of solar cells, where each solar cell is the solar cell described in any of the embodiments of the disclosure; a plurality of connecting members, where each connecting member is configured to electrically connect the first main busbar of one solar cell of two adjacent solar cells with the second main busbar of another solar cell of the two adjacent solar cells; at least one encapsulation adhesive film each configured to cover a surface of a respective cell string; and at least one cover plate each configured to cover a surface of a respective encapsulation adhesive film facing away from the at least one cell string.

In some embodiments, the photovoltaic module further includes at least one electrical connection wire, where the one edge electrode is electrically contacted with the n₁ first main busbars of one solar cell of two adjacent solar cells, and a respective electrical connection wire is electrically connected with the one edge electrode, such that the respective electrical connection wire is electrically connected with second main busbars of the other solar cell of the two adjacent solar cells; or the other edge electrode is electrically connected with the n₂ second main busbars of the one solar cell of the two adjacent solar cells, and the respective electrical connection wire is electrically connected with the other edge electrode, such that the respective electrical connection wire is electrically connected with first main busbars of the other solar cell of the two adjacent solar cells.

### BRIEF DESCRIPTION OF THE DRAWINGS

FIG. 1 is a schematic structural diagram of a solar cell according to embodiments not part of the invention.
FIG. 2 is a partial schematic structural diagram of the solar cell according to embodiments not part of the invention.
FIG. 3 is a cross-sectional view of FIG. 2 along section A1-A2.
FIG. 4 is a cross-sectional view of FIG. 2 along section B1-B2.
FIG. 5 is a schematic structural diagram of a solar cell according to other embodiments not part of the invention.
FIG. 6 is schematic structural diagram of arrangement of electrodes in a solar cell according to embodiments not part of the invention.
FIG. 7 is a schematic structural diagram of a photovoltaic module according to embodiments of the present disclosure.
FIG. 8 is a cross-sectional view of FIG. 7 along section M1-M2.
FIG. 9 is a schematic structural diagram of a solar cell in a photovoltaic module according to embodiments of the present disclosure.
FIG. 10 is a schematic structural diagram of a photovoltaic module according to embodiments of the present disclosure.
FIG. 11 is a cross-sectional view of FIG. 10 along section M5-M6.
FIG. 12 is a cross-sectional view of FIG. 10 along section M3-M4.
FIG. 13 is a schematic structural diagram of a solar cell in a photovoltaic module according to embodiments not part of the invention.
FIG. 14 is a cross-sectional view of FIG. 13.
FIG. 15 is a schematic structural diagram of a solar cell in a photovoltaic module according to embodiments not part of the invention.
FIG. 16 is a cross-sectional view of FIG. 15.
FIG. 17 is a schematic structural diagram of a solar cell in a photovoltaic module according to embodiments of the present disclosure.
FIG. 18 is a schematic structural diagram of a conductive structure in a photovoltaic module according to embodiments of the present disclosure.
FIG. 19 is a schematic structural diagram of a conductive structure and a main busbar in a photovoltaic module according to embodiments of the present disclosure.
FIG. 20 is a schematic structural diagram of a conductive structure and a main busbar in a photovoltaic module according to other embodiments of the present disclosure.
FIG. 21 is a schematic structural diagram of a photovoltaic module according to other embodiments of the present disclosure.
FIG. 22 is a cross-sectional view of FIG. 21 along section M5-M6.
FIG. 23 is a first schematic structural diagram of a solar cell according to embodiments of the present disclosure.
FIG. 24 is a partial enlarged view of part C in FIG. 23.
FIG. 25 is a cross-sectional view of FIG. 24 along section A1-A2.
FIG. 26 is a cross-sectional view of FIG. 24 along section B1-B2.
FIG. 27 is a second schematic structural diagram of a solar cell according to embodiments of the present disclosure.
FIG. 28 is a third schematic structural diagram of a solar cell according to embodiments of the present disclosure.
FIG. 29 is a schematic structural diagram of arrangement of first connection electrodes and second connection electrodes in the solar cell according to embodiments of the present disclosure.
FIG. 30 is a schematic structural diagram of arrangement of first connection electrodes and second connection electrodes in the solar cell according to other embodiments of the present disclosure.
FIG. 31 is a fourth schematic structural diagram of a solar cell according to embodiments of the present disclosure.
FIG. 32 is a fifth schematic structural diagram of a solar cell according to embodiments of the present disclosure.
FIG. 33 is a schematic structural diagram of a photovoltaic module according to other embodiments of the present disclosure.
FIG. 34 is a cross-sectional view of FIG. 33 along section M7-M8.
FIG. 35 is a schematic structural diagram of a solar cell in a photovoltaic module according to other embodiments of the present disclosure.

### DETAILED DESCRIPTION OF THE EMBODIMENTS

In view of the above, the yield of solar cells and photovoltaic modules needs to be improved.

According to some embodiments of the present disclosure, a photovoltaic module is provided and includes: at least one cell string each formed by connecting a plurality of solar cells through a plurality of connecting members, where each solar cell includes first main busbars and second main busbars disposed on a same surface of the solar cell, each connecting member is used for electrically connecting a first main busbar of one solar cell of two adjacent solar cells and a second main busbar of the other solar cell of the two adjacent solar cells, and the first main busbar is one of a positive electrode and a negative electrode, and the second main busbar is the other of the positive electrode and the negative electrode. The photovoltaic module further includes conductive structures, where each conductive structure is disposed between two adjacent solar cells, and the conductive structure has a first surface and a second surface that are disposed opposite to each other. The first surface is in contact with a surface of each of the two adjacent solar cells, and the second surface is electrically connected with connecting members. The photovoltaic module further includes at least one encapsulation adhesive film for covering surfaces of each cell string and a surface of each conductive structure; and at least one cover plate for covering a surface of each encapsulation adhesive film facing away from the cell strings.

In some embodiments, the conductive structure includes an insulating layer and a conductive layer. The insulating layer has one side in contact with one side of the conductive layer and has the other side constituting the first surface, and the conductive layer has the other side constituting the second surface.

In some embodiments, a material of the insulating layer includes: polyethylene (PE), ethylene-vinyl acetate copolymer (EVA), or polyethylene terephthalate (PET). A material of the conductive layer includes aluminum, aluminum tin, or copper.

In some embodiments, the insulating layer includes an adhesive layer.

In some embodiments, a material of the adhesive layer is the same as the material of the at least one encapsulation adhesive film.

In some embodiments, the solar cell further includes: m₁ first main busbars and m₂ second main busbars arranged alternatingly, and at least one edge electrode, where the m₁ first main busbars are formed over the at least one edge electrode, and the edge electrode is electrically connected with n₁ first main busbars, where 1 < n₁ ≤ m₁.

In some embodiments, the photovoltaic module further includes at least one electrical connection wire. The edge electrode is electrically connected with the n₁ first main busbars of one solar cell of two adjacent solar cells, and the electrical connection wire is electrically connected with the edge electrode, such that the electrical connection wire is electrically connected with second main busbars of the other solar cell of the two adjacent solar cells. The first surface is electrically connected with the electrical connection wire.

In some embodiments, the conductive structure has a first edge facing the first main busbars in the first direction and extending in the second direction, the first main busbar has a second edge facing the conductive structure in the first direction and extending in the second direction, and a distance between the first edge and the second edge ranges from 0mm to 2mm, wherein the plurality of solar cells are arranged in the first direction.

In some embodiments, the second main busbar is spaced from the first edge by a distance greater than 0, and the conductive structure includes a conductive layer having the first surface and the second surface that are disposed opposite to each other.

In some embodiments, the first edge is in contact with the first main busbar.

In some embodiments, there is a gap between each two adjacent solar cells, and the conductive structure is at least partially disposed in the gap.

In some embodiments, both ends of the first surface in the first direction are in contact with surfaces of two adjacent solar cells, respectively.

In some embodiments, a ratio of an area of an overlapping region between the first surface and the solar cell to a surface area of the first surface ranges from 1/10 to 1.

According to some embodiments of the present disclosure, a solar cell is provided and includes a substrate and a passivation layer formed over the substrate; finger electrodes arranged in a first direction and each finger electrode extends in a second direction, the finger electrodes penetrating the passivation layer to be electrically connected with the substrate. The finger electrode includes rows of first finger electrodes and rows of second finger electrodes alternatingly arranged in the first direction, where each row of first finger electrodes is between two adjacent rows of second finger electrodes. The solar cell further includes main busbars arranged in the second direction, and the main busbars are formed over the passivation layer. A respective main busbar is electrically connected with a portion of each of corresponding finger electrodes. The main busbars include m₁ first main busbars and m₂ second main busbars arranged alternatingly along the second direction. A respective first main busbar is electrically connected with a portion of each row of rows of first finger electrodes, and a respective second main busbar is electrically connected with a portion of each row of rows of second finger electrodes. The respective first main busbar is one of a positive electrode and a negative electrode, and the respective second main busbar is the other of the positive electrode and the negative electrode. The solar cell further includes at least two first connection electrodes. The at least two first connection electrodes penetrate the passivation layer to be electrically connected to the substrate. One of the at least two first connection electrodes is electrically connected with n₁ adjacent first main busbars, where 1 < n₁< m₁. The solar cell further includes at least two second connection electrodes penetrating the passivation layer to be electrically connected to the substrate, where one of the at least two second connection electrodes is electrically connected with n₂ adjacent second main busbars, where 1 < n₂ < m₂.

In some embodiments, each respective first main busbar includes a plurality of first sub-main busbars arranged in sequence along the first direction. Each respective first connection electrode is electrically connected with a corresponding first sub-main busbar of each of at least two adjacent first main busbars. Each respective second main busbar includes a plurality of second sub-main busbars arranged in sequence in the first direction. Each respective second connection electrode is electrically connected with a corresponding second sub-main busbar of each of at least two adjacent second main busbars.

In some embodiments, the plurality of second sub-main busbars are spaced by a plurality of second disconnection regions in the first direction, where each pair of adjacent second sub-main busbars in the respective second main busbar are separated by a corresponding second disconnection region of the plurality of second disconnection regions. Each first connection electrode is located in a second spacer region and electrically connected with two adjacent first main busbars. the plurality of first sub-main busbars are spaced by a plurality of first disconnection regions in the first direction, where each pair of adjacent first sub-main busbars in the respective first main busbar are separated by a corresponding first disconnection region of the plurality of first disconnection regions. Each second connection electrode is located in a first disconnection region and electrically connected with two adjacent second main busbars.

In some embodiments, the first disconnection region is disposed adjacent to the second disconnection region in the second direction, and each second connection electrode is disposed between a first sub-main busbar and a corresponding first connection electrode.

In some embodiments, the first connection electrodes are arranged in a staggered manner in the first direction, and the second connection electrodes are arranged in a staggered manner in the first direction.

In some embodiments, the first connection electrodes are arranged in a stepped manner in the first direction, and the second connection electrodes are arranged in a stepped manner in the first direction.

In some embodiments, n₁ ≤ (1/2) m₁; and/or, n₂ ≤ (1/2) m₂.

In some embodiments, the at least two first connection electrodes include a material same as a material of the finger electrodes, and the at least two second connection electrodes include a material same as that of the finger electrodes.

In some embodiments, each of the at least two first connection electrodes has a width greater than or equal to a width of a respective finger electrode in the first direction, and each of the at least two second connection electrodes has a width greater than or equal to the width of the respective finger electrode in the first direction.

According to some embodiments of the present disclosure, a photovoltaic module is provided, and includes: a plurality of cell strings each formed by connecting a plurality of solar cells described in any of the above embodiments. The solar cell includes first main busbars, and second main busbars on a same surface of the solar cell. The photovoltaic module further includes connecting members, where each connecting member is used for electrically connecting a first main busbar of one solar cell of two adjacent solar cells and a second main busbar of the other solar cell of two adjacent solar cells; at least one encapsulation adhesive film for covering surfaces of each cell string; and at least one cover plate for covering a surface of each encapsulation adhesive film facing away from the cell strings.

It can be found that one of the reasons for the poor yield of the solar cells and the photovoltaic modules is as follows. For current back-contact solar cells (e.g., interdigitated back-contact (IBC) cells), first electrodes and second electrodes in the IBC cell are arranged on the back surface of the substrate, and first main busbars and second main busbars are all arranged on the back surface of the substrate. A respective first electrode is electrically connected with a respective first main busbar, and a respective second electrode is electrically connected with a respective second main busbar. The respective first electrode intersect the respective first main busbar (e.g., an extension direction of the respective first main busbar is the same as an arrangement direction of the first electrodes), and the respective second electrode intersect the respective second main busbar (e.g., an extension direction of the respective second main busbar is the same as an arrangement direction of the second electrodes). In this way, electrical insulation between the first electrodes and the second main busbars that have different polarities, and electrical insulation between second electrodes and first main busbars that have different polarities need to be achieved. However, there may be a situation where the first main busbars may be electrically connected with part of the first electrodes, and may be electrically insulated from the remaining first electrodes and the first main busbars could not collect the carriers of all the first electrodes. If there is a problem with one of the first main busbars or poor soldering between the first main busbar and a ribbon, current of a plurality of first electrodes to which the first main busbar is connected is unable to be collected, thereby affecting the yields of the solar cells as well as the photovoltaic modules, thus affecting the yield of the solar cells and the photovoltaic modules. Similarly, the second main busbars may have similar problems, which may also affect the yield of the solar cells and the photovoltaic modules.

Embodiments of the disclosure provide a solar cell. The solar cell includes at least one edge electrode, and electric contact between the at least one edge electrode and first main busbars and/or second main busbars is achieved. That is, using one edge electrode can connect busbars (e.g., positive electrodes or negative electrodes) of the same polarity in the solar cell in series, i.e., one solar cell forms an integral electrode, thus ensuring that the first main busbar and each first finger electrode to be in a state of mutual conduction, thereby avoiding the probability that the efficiency and yield of the cells are reduced due to fault of one of the first main busbars. In addition, current collected by the first finger electrode located at the edge of the substrate can be collected in the state of conduction, thus improving the collection efficiency of the cell. Similarly, the cell efficiency can be improved by improving the cell collection efficiency of the second finger electrodes.

In addition, since the electrodes in the solar cell are all in a conduction state, the problem of poor appearance between each of the first main busbars and corresponding first finger electrodes due to different preparation processes can be avoided. The interconnection between the first main busbars and the interconnection between the second main busbars can also avoid the problem of reduced cell efficiency due to broken of one of the main busbars.

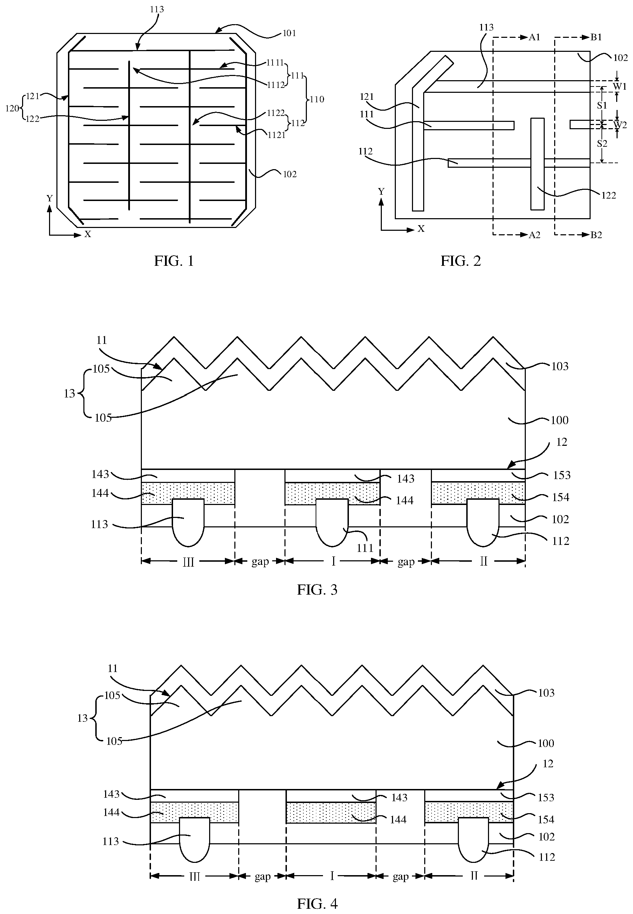

Referring to FIGS. 1 and 3, embodiments of the disclosure provide a solar cell. The solar cell includes a substrate 100 and a passivation layer 102 formed over a surface of the substrate 100. The substrate 100 has two opposite first boundaries 101 arranged along a first direction Y. The solar cell includes finger electrodes 110 arranged in the first direction Y and each finger electrode 110 extends in a second direction X, and the finger electrodes 110 penetrate the passivation layer 102 to be electrically connected to the substrate 100, the finger electrodes 110 including rows of first finger electrodes 111 and rows of second finger electrodes 112 alternatingly arranged in the first direction Y. Each row of first finger electrodes 111 is between two adjacent rows of second finger electrodes 112. The solar cell further includes main busbars 120 arranged in the second direction X, and the main busbars 120 are formed over the surface of the passivation layer 102. A respective main busbar 120 is electrically connected with a portion of each of corresponding finger electrodes 110. The main busbars 120 include m₁ first main busbars 121 and m₂ second main busbars 122 arranged alternatingly along the second direction X. A respective first main busbar 121 is electrically connected with a portion of each row of the rows of first finger electrodes 111, and a respective second main busbar 122 is electrically connected with a portion of each row of the rows of second finger electrodes 112. The respective first main busbar 121 is one of a positive electrode and a negative electrode, and the respective second main busbar 122 is the other of the positive electrode and the negative electrode. The solar cell further includes at least one edge electrode 113. Each edge electrode 113 extends in the second direction X. Each edge electrode 113 is between a corresponding first boundary 101 of the two opposite first boundaries and each of the finger electrodes. The edge electrode 113 at least partially penetrates the passivation layer 102 to be electrically connected to the substrate 100, and the edge electrode 113 is electrically connected with n₁ first main busbars 121, where 1 < n₁ ≤ m₁, n₁ and m₁ are natural numbers.

In some embodiments, each row of first finger electrodes 111 including a corresponding set of first sub-electrodes arranged at intervals in the second direction X, and each row of second finger electrodes 112 including a corresponding set of second sub-electrodes arranged at intervals in the second direction X. A respective first main busbar 121 is electrically connected with a respective first sub-electrode of each row of the rows of first finger electrodes 111, and a respective second main busbar 122 is electrically connected with a respective second sub-electrode of each row of the rows of second finger electrodes 112.

In some embodiments, referring to FIG. 3, the solar cell is a back-contact solar cell, and the back-contact solar cell is a solar cell in which electrodes of different polarities (positive and negative electrodes) are disposed on the backside of the substrate.

Referring to FIG. 3, in some embodiments, a material of the substrate 100 may include an elemental semiconductor material. Specifically, the elemental semiconductor material may be a single element, for example, silicon or germanium. The elemental semiconductor material may be in a monocrystalline state, a polycrystalline state, an amorphous state, or a microcrystalline state (a state having both a monocrystalline state and an amorphous state), for example, the silicon may be at least one of monocrystalline silicon, polycrystalline silicon, amorphous silicon, and microcrystalline silicon.

In some embodiments, the material of the substrate 100 includes a compound semiconductor material. Common compound semiconductor materials include, but are not limited to, silicon germanium, silicon carbide, gallium arsenide, indium gallium, perovskite, cadmium telluride, copper indium selenium, etc. The substrate 100 may also include a sapphire substrate, a silicon-on-insulator substrate, or a germanium-on-insulator substrate.

In some embodiments, the substrate 100 includes an N-type semiconductor substrate or a P-type semiconductor substrate. The N-type semiconductor substrate is doped with an N-type doping element, and the N-type doping element may be any one of group V elements such as phosphorus (P), bismuth (Bi), antimony (Sb), arsenic (As), etc. The P-type semiconductor substrate is doped with a P-type doping element, and the P-type doping element may be any one of group III elements such as boron (B), aluminum (Al), gallium (Ga), indium (In), etc.

In some embodiments, the substrate 100 has a first surface 11 and a second surface 12 opposite the first surface 11. The first surface 11 of the substrate 100 is a front surface and the second surface 12 is a rear surface. The front surface is used as a light receiving surface for receiving incident light, and the rear surface is used as a backlight surface. In some embodiments, the backlight surface can also receive incident light, but the efficiency of receiving the incident light by the backlight surface is weaker than that of the light receiving surface.

It is to be noted that the incident light received by the light receiving surface is directly irradiated on the solar cell by sunlight, and the incident light received by the backlight surface is caused by the reflection of the ground and other objects and the refraction of films on the substrate.

In some embodiments, the first surface 11 has a first textured structure 13. The first textured structure 13 includes a plurality of protrusion structures 105. The first surface 11 has a front surface field (FSF), and doped ions of the FSF have a conductivity type the same as a conductivity type of doped ions in the substrate 100. Surface minority concentration is reduced by using the field passivation effect, so that a surface recombination rate can be reduced, a series resistance can be reduced, and electron transmission capability can be improved.

In some embodiments, the substrate 100 has first regions I and second regions II that are alternatingly arranged in the first direction Y. The first region I is one of a P region and an N region and the second region II is the other of the P region and the N region. Each P region and an adjacent N region are spaced by a spacing region gap therebetween. A respective row of first finger electrodes 111 is disposed in a corresponding first region I and a respective row of second finger electrodes 112 is disposed in a corresponding second region II.

In some embodiments, there is no spacing region *gap* between each P region and the adjacent N region and there is an insulating film layer between each P region and the adjacent N region to achieve insulation between the P region and the N region, thereby achieving insulation between the first finger electrodes 111 and the second finger electrodes 112.

In some embodiments, the substrate 100 further has at least one third region III, and the at least one third region III is located at the edge of the substrate 100. The third region III has the same characteristics as an adjacent first region I or has the same characteristics as an adjacent second region II. For example, as shown in FIG. 3, the third region III and the first region I are adjacent to each other and have a spacing region *gap* between the third region III and the first region I, the third region III and the first region I have a same polarity. For example, if the first region I is an N region, the third region III is also an N region. In some embodiments, the polarity of the third region III is different from that of the first region I. For example, if the first region I is an N region, the third region III is a P region, such that the edge electrode located on the third region III is electrically connected with the second main busbars.

In other words, the respective edge electrode has a polarity same as/different from a polarity of a corresponding finger electrode adjacent to the respective edge electrode, wherein there is no other finger electrode between the respective edge electrode and the corresponding finger electrode.

In some embodiments, referring to FIG. 3, the spacing region *gap* is flush with the P region and the N region i.e., part of the substrate 100 corresponding to the spacing region *gap* is not etched and insulation between the P region and the N region is achieved by an insulating film layer, for example, the insulating film layer may be the passivation layer 102.

In some embodiments, the spacing region *gap* is lower than the P region and the spacing region *gap* is lower than the N region. That is, the second surface has grooves at the spacing regions *gap,* where each groove extends from the second surface toward the first surface. The grooves are used to realize automatic isolation between regions of different conductivity types, which can eliminate the leakage caused by the PN junctions formed by heavily doped P regions and N regions in the IBC cell and avoid affecting the cell efficiency.

In some embodiments, a surface of the spacing region *gap* may have a polished surface structure or the surface of the spacing region *gap* may have a second textured structure. The first textured structure has roughness larger than or equal to that of the second textured structure.

Herein, "roughness" refers to an arithmetic mean of absolute values of vertical deviations (height differences in a vertical direction) of peaks and troughs, within a sampling length of the surface, relative to a reference horizontal line. The roughness can be measured by comparison method, the light cutting method, the interference method, and needle tracing method.

In some embodiments, the solar cell further includes first dielectric layers 143 and first doped semiconductor layers 144. A respective first dielectric layer 143 and a respective first doped semiconductor layer 144 are formed over a corresponding first region I. The solar cell further includes second dielectric layers 153 and second doped semiconductor layers 154. A respective second dielectric layer 153 and a respective second doped semiconductor layer 154 are formed over a corresponding second region II. The passivation layer 102 is formed over the first doped semiconductor layers 144 and the second doped semiconductor layers 154, the respective row of first finger electrodes 111 penetrates the passivation layer 102 to be electrically connected with the respective first doped semiconductor layer 144, and the respective row of second finger electrodes 112 penetrates the passivation layer 102 to be electrically connected with the respective second doped semiconductor layer 154. That is, a respective row of first finger electrodes 111 is formed over and electrically connected with a portion of the respective first doped semiconductor layer 144 in a corresponding first region, and a respective row of second finger electrodes 112 is formed over and electrically connected with a portion of the respective second doped semiconductor layer 154 in a corresponding second region. The passivation layer 102 is formed over the spacing regions *gap* and over a portion of each first doped semiconductor layer 144 not under the row of first finger electrodes 111 and over a portion of each second doped semiconductor layer 154 not under the row of first finger electrodes 112.

In some embodiments, arrangement of film layers on the third region III is the same as arrangement of film layers on the first region I, i.e., there are a first dielectric layer and a first doped semiconductor layer on a corresponding third region III. The edge electrode is electrically connected with the first doped semiconductor layer after penetrating the passivation layer. In other embodiments, arrangement of film layers on the third region III is the same as the arrangement of the film layers on the second region II, i.e., the solar cell has a second dielectric layer and a second doped semiconductor layer on the third region III, and the edge electrode is electrically connected with the second doped semiconductor layer after penetrating the passivation layer.

In some embodiments, the first doped semiconductor layer 144 is doped with one of an N-type doping element and a P-type doping element, and the second doped semiconductor layer 154 is doped with the other of the N-type doping element and the P-type doping element.

In some embodiments, at least one of the first dielectric layer 143 and the second dielectric layer 153 may be a tunneling dielectric layer, and a material of the tunneling dielectric layer includes silicon oxide or silicon carbide.

In some embodiments, at least one of the first doped semiconductor layer 144 and the second doped semiconductor layer 154 may be at least one of a doped amorphous silicon layer, a doped polysilicon layer, a doped microcrystalline silicon layer, a doped silicon carbide layer, and a doped crystalline silicon layer.

In some embodiments, the solar cell may include a first intrinsic dielectric layer, a first doped amorphous silicon layer, and a first transparent conductive layer on the first region I. The first intrinsic dielectric layer is formed over the second surface, the first doped amorphous silicon layer is disposed on the first intrinsic dielectric layer, and the first transparent conductive layer is disposed on the first doped amorphous silicon layer. The solar cell may further include a second intrinsic dielectric layer, a second doped amorphous silicon layer, and a second transparent conductive layer on the second region II. The second intrinsic dielectric layer is formed over the second surface, the second doped amorphous silicon layer is disposed on the second intrinsic dielectric layer, and the second transparent conductive layer is disposed on the second doped amorphous silicon layer. The first doped amorphous silicon layer is doped with one of an N-type doping element and a P-type doping element, and the second doped amorphous silicon layer is doped with the other of an N-type doping element and a P-type doping element.

With continued reference to FIGS. 3 and 4, the solar cell further includes a front passivation layer 103 formed over the front surface of the substrate 100.

In some embodiments, a material of each of at least one of the front passivation layer 103 and the passivation layer 102 includes one or more of materials, such as, silicon oxide, silicon nitride, silicon oxynitride, silicon carbonitride, titanium oxide, hafnium oxide, and aluminum oxide.

In some embodiments, each of at least one of the front passivation layer 103 and the passivation layer 102 includes a stacked film layer including at least a first passivation layer and a second passivation layer. A material of the first passivation layer may be one or more of materials, such as, silicon oxide, silicon nitride, silicon oxynitride, silicon carbonitride, titanium oxide, hafnium oxide, and aluminum oxide. A material of the second passivation layer may be one or more of materials such as silicon oxide, silicon nitride, silicon oxynitride, silicon carbonitride, titanium oxide, hafnium oxide, and aluminum oxide.

In some embodiments, the material of the front passivation layer 103 is the same as the material of the passivation layer 102, and the front passivation layer 103 and the passivation layer 102 are prepared in a same preparation process.

In some embodiments, the first finger electrodes 111, the second finger electrodes 112, and the edge finger electrodes 113 are all prepared as burn-through pastes. The first finger electrode 111 burns through the passivation layer 102 to be electrically connected with the first doped semiconductor layer 144, the second finger electrode 112 burns through the passivation layer 102 to be electrically connected with the second doped semiconductor layer 154, and the edge electrode 113 burns through the passivation layer 102 to be electrically connected with the first doped semiconductor layer 144.

For example, the first finger electrodes 111 are formed as follows. A metal paste is printed on a portion of a surface of the passivation layer 102 using a screen-printing process. The metal paste may include at least one of silver, aluminum, copper, tin, gold, lead, or nickel.

With continued reference to FIG. 1, each of the first finger electrodes 111 and the second finger electrodes 112 extends in the second direction X, and the first direction Y and the second direction X may be perpendicular to each other, or may have an angle of less than 90° therebetween, for example, 60°, 45°, 30°, and the like, as long as the first direction Y and the second direction X may not be in the same direction. In order to facilitate explanation and understanding, in embodiments of the disclosure, the first direction Y and the second direction X being perpendicular to each other is taken as an example for illustration. In specific scenarios, the angle between the first direction Y and the second direction X can be adjusted according to actual needs and usage scenarios, which is not limited in the embodiments of the disclosure.

In some embodiments, the substrate further has two second boundaries that face each other in the second direction X. A junction of one first boundary 101 and one second boundary, a junction of the second boundary and the other first boundary 101, a junction of the other first boundary 101 and the other second boundary, and a junction of the other second boundary and the first boundary 101 have chamfers. The reason for formation of the chamfers is that a monocrystal silicon rod can only be made to have a round shape due to extraction limitation of the monocrystal silicon process for preparing the substrate in conventional solar cells, the silicon rod is sliced after coming out, that is, the cross-section of the silicon rod is cut into the appearance of a monocrystal silicon wafer (after calculating the area, an area of illumination is maximized in a unit, the material of the silicon rod is saved to a greatest extent, and it is also convenient for the production of cells and modules), and the chamfers are often set at various junction of boundaries of the substrate to reduce external stress of the silicon wafer and avoid micro-damage at the corners of the silicon wafer.

In some embodiments, providing the edge electrode 113 may increase the collection rate of current generated by the substrate at the first boundary. In addition, providing the edge electrode 113 to be electrically connected with the first main busbars can realize the electrical connection between all the first finger electrodes 111 and the first main busbars 121, thereby improving the cell collection rate and reducing the cell defective rate.

In some embodiments, providing the edge electrode 113 can improve the collection efficiency of the solar cells by 1% to 5%, and reduce the defective rate of the cells by less than 5%, thereby improving the photoelectric conversion efficiency of the solar cells and the high cost-effectiveness of the photovoltaic module.

In some embodiments, the edge electrode 113 is a whole grid line (electrode) connecting adjacent first main busbars 121, and an extension direction of the edge electrode 113 is perpendicular to the extension direction of each first main busbar 121 or the extension direction of the edge electrode 113 intersects or is parallel to the extension direction of the first finger electrode 111, so that a printing screen for the existing finger electrodes 110 can be subjected to partially modifying or the edge electrodes 113 can be printed by performing another printing process, thereby reducing the improvement of the current process and improving the compatibility and applicability of the device.

In some embodiments, the edge electrode 113 is a grid line electrically connected to part of the first main busbars, and a connection electrode electrically connecting the remaining first main busbars is located inside the cell, such that the solar cell can achieve electrically connection of the first main busbars and the first finger electrodes 111 through the edge electrode 113 and the connection electrode.

In some embodiments, the edge electrode 113 includes a same material as the finger electrodes 110. The edge electrode 113 has the same paste as the paste of the finger electrodes 110. That is, the edge electrode 113 is made of a burn-through paste, and the edge electrode 113 also penetrates the passivation layer to be electrically connected with a corresponding first doped semiconductor layer. Therefore, the edge electrode 113 can not only realize the current penetration of the first main busbars 121, but also collect the current of the surface adjacent to the first boundary 101 of the substrate, thereby increasing the collection path and improving efficiency of the current collection.

In some embodiments, the paste of the edge electrode 113 is the same as that of the main busbar 120, i.e., the edge electrode 113 is made of a non-burn-through paste, and the edge electrode 113 is located on the surface of the passivation layer. In this way, the first regions I and II on the surface of the substrate below the edge electrode 113 may not need to be typeset to avoid short circuit caused by the electrical contact between the edge electrode 113 and the doped region of another polarity. In addition, the edge electrode 113 may not damage to the passivation layer, thereby ensuring integrity of the film layer of the passivation layer, improving the passivation effect of the passivation layer on the substrate, facilitating the reduction of optical loss of the solar cell, and improving the photoelectric conversion efficiency of the solar cell. In addition, since the non-burn-through paste has no excessive glass powder to damage the PN junction, the metal recombination can be effectively reduced, the open-circuit voltage of the solar cell can be improved, and the conversion efficiency of the solar cell can be improved.

The conventional paste includes a mixture of metal powder, glass powder, and an organic carrier. The non-burn-through paste refers to the paste containing lower glass powder content than that the conventional paste, having a weak burn-through capability in the sintering process, and not required or able to burn the paste of the passivation layer. The burn-through paste refers to the paste having a strong burn-through capability and able to burn through the passivation layer in the sintering process.

In some embodiments, referring to FIGS. 1 and 2, each row of first finger electrodes 111 includes first sub-electrodes 1111 arranged in the second direction X, and part of the passivation layer between each two adjacent first sub-electrodes 1111 defines a first spacer region 1112. That is, each row of first finger electrodes 111 includes a corresponding set of first sub-electrodes spaced from each other by a plurality of first spacer regions 1112 in the second direction X such that each pair of adjacent first sub-electrodes 1111 in the row of first finger electrodes 111 are separated by a corresponding first spacer region 1112 of the first spacer regions 1112. A respective second main busbar 122 is disposed on a corresponding first spacer region 1112. A respective first main busbar 121 is electrically connected with a corresponding first sub-electrode 1111 of each row of first finger electrodes 111. Each row of second finger electrodes 112 includes second sub-electrodes 1121 arranged in the second direction X, and part of the passivation layer between each two adjacent second sub-electrodes 1121 defines a second spacer region 1122. That is, each row of second finger electrodes 112 includes a corresponding set of second sub-electrodes spaced from each other by a plurality of second spacer regions 1122 in the second direction X such that each pair of adjacent second sub-electrodes 1121 in the row of second finger electrodes 112 are separated by a corresponding second spacer region 1122 of the second spacer regions 1122. A respective first main busbar 121 is disposed on a corresponding second spacer region 1122. A respective second main busbar 122 is electrically connected with a corresponding second sub-electrode 1121 of each row of second finger electrodes 112.

In some embodiments, a width W1 of the edge electrode 113 in the first direction Y is greater than or equal to a width W2 of the finger electrode 110 in the first direction Y. The width W2 of the finger electrode 110 in the first direction Y may be at least one of a width of the first finger electrode 111 in the first direction Y or a width of the second finger electrode 112 in the second direction Y. Therefore, the edge electrode 113 has a large width to realize the electrical connection between the first main busbars 121, and the edge electrode 113 does not have excessive influence on the arrangement of the original electrodes. When the width of the edge electrode 113 is equal to the width of the finger electrode 110, the edge electrode 113 can be prepared concurrently with the finger electrode 110 without affecting the original process, thereby improving the compatibility of the original device and the apparatus, and reducing the preparation cost of the solar cell.

In some embodiments, the width of the edge electrode 113 is greater than the width of the finger electrode 110, such that the wider edge electrode 113 may increase the collection area and the collection probability at the edge near the first boundary 101, thereby improving the cell collection efficiency. The wider edge electrode 113 can also be used as the end point of the first main busbar close to the first boundary, and the wider edge electrode 113 can improve the accuracy of the first main busbar overlapping on the edge electrode 113. Since the edge electrode can share the welding pressure of the first main busbar, the first main busbar 121 can also be correspondingly set to be shorter. That is, an end of the first main busbar 121 facing the first boundary 101 can be flush with or lower than a side of the edge electrode 113 facing the first boundary 101, so that a distance between a welding point of the ribbon and the first main busbar 121 and the first boundary 101 is set to be relatively farther, thereby reducing the probability of damage of the cell.

In some embodiments, the width W1 of the edge electrode 113 in the first direction Y ranges from 10µm to 55µm. The width W1 of the edge electrode 113 in the first direction Y may be 10µm ~ 16µm, 16µm ~ 22µm, 22µm ~ 30µm, 30µm ~ 38µm, 38µm ~ 46µm, or 46µm ~ 55µm. When the width of the edge electrode 113 in the first direction is within any of the above-mentioned ranges, the edge electrode 113 has a strong ability to collect carriers at the edge, and the edge electrode 113 has a certain distance from the first boundary 101, thereby reducing the probability of damage at the first boundary.

In some embodiments, the edge electrode 113 is spaced from an adjacent finger electrode 110 (where "adjacent" means that there is no other electrodes between the edge electrode 113 and adjacent finger electrode 110) by a first pitch S1, and the first pitch S1 is less than or equal to a distance S2 between each first finger electrode 111 and an adjacent second finger electrode 112 (where "adjacent" means that there is no other electrodes between the first finger electrode 111 and the second finger electrode 112). Thus, the pitch between the edge electrode 113 and the finger electrode 110 is appropriate, and the layout between the edge electrode 113 and the finger electrodes 110 can achieve a minimum carrier migration distance and a minimum migration loss on the substrate in a layout without wasting the shielding areas of the edge electrodes 113 and the finger electrode 110, thereby increasing the open circuit voltage of the solar cell.

It is to be noted that the first pitch illustrated in FIG. 2 of the embodiments of the present disclosure refers to a spacing between an axis of the edge electrode and an axis of the adjacent finger electrode, and there is no restriction on the first pitch in the embodiments of the present disclosure. For example, the first pitch can also be a distance between a side of the edge electrode facing the first boundary and the side of the adjacent finger electrode facing away from the first boundary or a shortest distance between the edge electrode and the adjacent finger electrode.

In some embodiments, the first pitch S1 ranges from 0.2 mm to 0.7 mm. The first pitch S1 is in a range of 0.2 mm ~ 0.35 mm, 0.35 mm ~ 0.46 mm, 0.46 mm ~ 0.58 mm, 0.58 mm ~ 0.63 mm, or 0.63 mm ~ 0.7 mm.

In some embodiments, the distance S2 between each first finger electrode 111 and the adjacent second finger electrode 112 ranges from 0.3 mm to 0.8 mm. The distance S2 between the first finger electrode 111 and the second finger electrode 112 that are adjacent to each other ranges from 0.3 mm to 0.35 mm, 0.35 mm to 0.43 mm, 0.43 mm to 0.5 mm, 0.5 mm to 0.58 mm, 0.58 mm to 0.66 mm, 0.66 mm to 0.72 mm, or 0.72 mm to 0.8 mm.

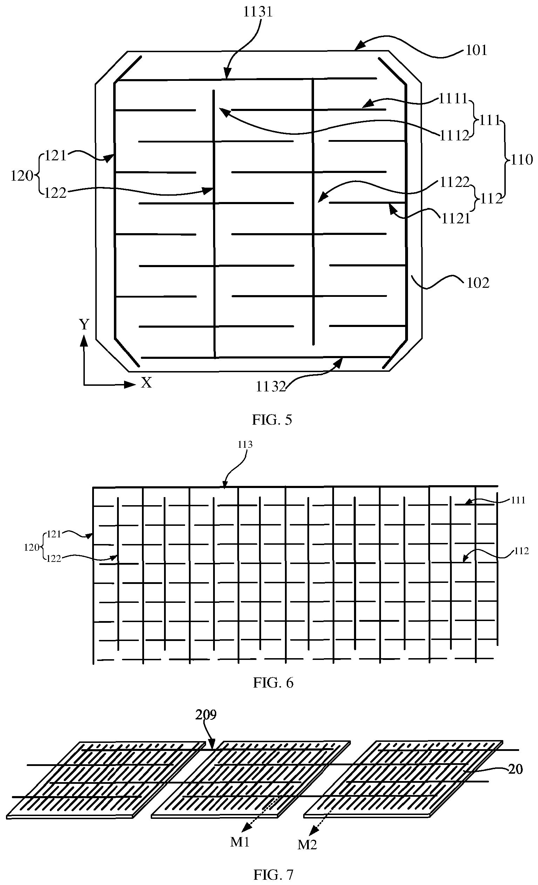

Referring to FIG. 5, the at least one edge electrode 113 is configured as two edge electrodes 113. One edge electrode 113 is electrically connected with the first main busbars 121, and the other edge electrode 113 is electrically connected with n₂ second main busbars 122, where 1 < n₂ ≤ m₂, and n₁, m₁, n₂, and m₂ are all natural numbers.

In some embodiments, the at least one edge electrode 113 includes a first edge electrode 1131 and a second edge electrode 1132. The first edge electrode 1131 is disposed between the first boundary and the second finger electrode 112 (or first finger electrode 111), and the first edge electrode 1131 is electrically connected with the first main busbars. The second edge electrode 1132 is disposed between the other first boundary and the first finger electrode 111 (or second finger electrode 112), and the second edge electrode 1132 is electrically connected with the second main busbar. According to the embodiments of the present disclosure, two edge electrodes 113 are arranged at two first boundaries to realize interconnection between the first main busbars and interconnection between the second main busbars, thereby improving the collection efficiency and the yield of the solar cells.

In some embodiments, providing the first edge electrode 1131 to be electrically connected with the first main busbars and providing the second edge electrode 1132 to be electrically connected with the second main busbars can improve the collection efficiency of the solar cell by 3% ~ 10%, and reduce the defective rate of the cell by less than 8%.

In some embodiments, using one edge electrode can connect busbars (e.g., positive electrodes or negative electrodes) of the same polarity in the solar cell in series, and one solar cell forms an integral electrode, i.e., one solar cell forms an integral electrode, thereby ensuring that the first main busbar and each first finger electrode 111 to be in a state of mutual conduction, thus avoiding the probability that the efficiency and yield of the cells are reduced due to fault of one of the first main busbars. In addition, the first finger electrode 111 located at the edge of the substrate can be collected due to the conduction of the first finger electrodes 111, thus improving the collection efficiency of the cells. Similarly, the cell efficiency can be improved by improving the cell collection efficiency of the second finger electrodes 112.

Furthermore, since the electrodes in the solar cell are all in a conduction state, the problem of poor appearance between each of the first main busbars 121 and corresponding first finger electrodes 111 due to different preparation processes can be avoided. The interconnection between the first main busbars 121 and the interconnection between the second main busbars 122 can also avoid the problem of reduced cell efficiency due to broken of one of the finger electrodes 110 or main busbars 120.

In some embodiments, one edge electrode 113 is electrically connected with the n₁ first main busbars 121, and the other edge electrode 113 is electrically connected with n₂ second main busbars 122, where 1 < n₁ < m₁, and 1 < n₂ < m₂. At least one connection electrode for connecting the remaining first main busbars and/or the remaining second main busbars is located inside the cell, and the connection electrodes can achieve the electrical connection between the remaining first main busbars 121 and the electrical connection between the remaining second main busbars 122. Therefore, with aid of the edge electrodes 113 and the connection electrodes, the electrical connection between the first main busbars 121 and the first finger electrodes 111 in the solar cell, and can achieve the electrical connection between the second main busbars 122 and the second finger electrodes 112 in the solar cell can be achieved.

For example, in some embodiments, the solar cell further includes at least one first connection electrode, and the at least one first connection electrode penetrates the passivation layer to be electrically connected with the substrate, where one first connection electrode is electrically connected to remaining m₁-n₁ first main busbars.

In some embodiments, the solar cell further includes at least one second connection electrode, and the at least one second connection electrode penetrates the passivation layer to be electrically connected with the substrate, where one second connection electrode is electrically connected to remaining m₂-n₂ second main busbars.

In some embodiments, a material of the first connection electrode is the same as the material of the finger electrode, and a material of the second connection electrode is the same as that of the finger electrode.

In some embodiments, a width of the first connection electrode in the first direction is greater than or equal to the width of the finger electrode, and a width of the second connection electrode in the first direction is greater than or equal to the width of the finger electrode.

In some embodiments, referring to FIG. 6, m₁ ≥ 8, and m₂ ≥ 8, for example, the number of the first main busbars may be 8, the number of the second main busbars may be 8, and the number of main busbars may be 16.

In some embodiments, the number of the first main busbars may be a natural number greater than 8 and the number of the second main busbars may be a natural number greater than 8.

In the solar cell of the embodiments of the present disclosure, the solar cell includes the at least one edge electrode 113, and the at least one edge electrode 113 is in electric contact with the first main busbars 121 and/or the second main busbars 122. That is, using one edge electrode can connect busbars (e.g., positive electrodes or negative electrodes) of the same polarity in the solar cell in series, i.e., one solar cell forms an integral electrode, thus ensuring that the first main busbar 121 and each first finger electrode 111 to be in a state of mutual conduction, thereby avoiding the probability that the efficiency and yield of the cells are reduced due to damage of one of the first main busbars 121. In addition, current collected by the first finger electrode 111 located at the edge of the substrate can be collected due to conduction of each first finger electrode 111, thus improving the collection efficiency of the cell. Similarly, the cell efficiency can be improved by improving the cell collection efficiency of the second finger electrodes 112.

In addition, since the electrodes in the solar cell are all in a conduction state, the problem of poor appearance between each of the first main busbars 121 and corresponding first finger electrodes 111 due to different preparation processes can be avoided. The interconnection between the first main busbars 121 and the interconnection between the second main busbars 122 can also avoid the problem of reduced cell efficiency due to broken of one of the finger electrodes 110 or main busbars 120.

Correspondingly, embodiments of the present disclosure further provide a photovoltaic module, which may include the solar cell provided in the above embodiments, and has the same or corresponding technical features as the above embodiments, which will not be described in detail herein.

Referring to FIGS. 7 to 9, another aspect of the embodiments of the present disclosure further provides a photovoltaic module. The photovoltaic module includes a plurality of cell strings each formed by connecting a plurality of solar cells 20 described in any of the above embodiments. The solar cell includes at least one edge electrode 113, first main busbars 121, and second main busbars 122. The photovoltaic module further includes connecting members 209 each for electrically connecting a first main busbar 121 of one solar cell 20 of two adjacent solar cells 20 and a second main busbar 122 of the other solar cell 20 of two adjacent solar cells 20; at least one encapsulation adhesive film 27 for covering surfaces of each cell string; and at least one cover plate 28 for covering a surface of each encapsulation adhesive film facing away from the cell strings.

In some embodiments, the plurality of cell strings may be electrically connected with each other through the connecting members 209, where each of the connecting members 209 is electrically connected with corresponding main busbars on the cells. For example, each connecting member has an end electrically connected with a first main busbar of a first cell, and has the other end electrically connected with a second main busbar of a second cell adjacent to the first cell.

In some embodiments, no spacing is provided between the cells, i.e., the cells overlap each other.

In some embodiments, the connecting members are electrically connected with finger electrodes on the cells.

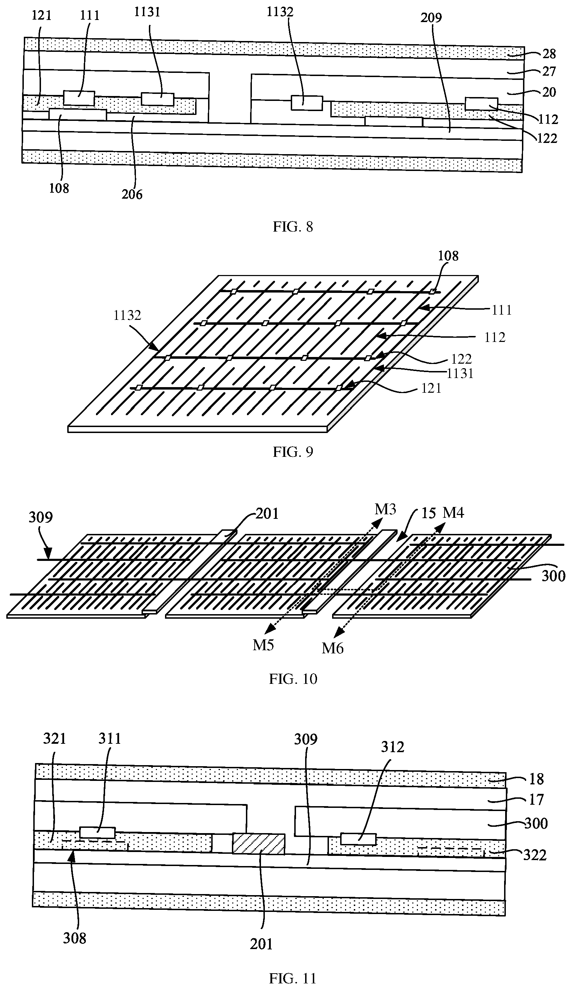

In some embodiments, with reference to FIG. 9, each solar cell has solder pads 108 for effecting soldering between the connecting members 209 and the main busbars.

In some embodiments, referring to FIG. 8, the photovoltaic module further includes an insulating film 206 covering a portion of the surface of the solar cell 20. For example, the insulating film 206 is disposed on a portion of a surface of each first main busbar and each first finger electrode to achieve electrical insulation between the second main busbar and the first main busbar when the connecting member and the second main busbar are electrically connected. The insulating film 206 exposes a surface of the solder pad 108, and the insulating film 206 is also located between the connecting member 209 and the solar cell, thereby achieving soldering between the connecting member and the corresponding main busbar, avoiding electrical contact between the connecting member and the main busbar of another polarity, and improving the yield. For example, if the connecting member is welded with the first main busbar, the insulating film achieves electrical insulation between the connecting member and the second main busbar.

In some embodiments, the at least one encapsulation adhesive film 27 includes a first encapsulation adhesive film and a second encapsulation adhesive film. The first encapsulation adhesive film is disposed on one of the front surface or back surface of the solar cell, and the second encapsulation adhesive film is disposed on the other of the front surface or back surface of the solar cell. Specifically, at least one of the first encapsulation adhesive film and the second encapsulation adhesive film may be an organic encapsulation adhesive film such as polyvinyl butyral (PVB) adhesive film, ethylene-vinyl acetate copolymer (EVA) adhesive film, polyethylene octene co-elastomer (POE) adhesive film or polyethylene terephthalate (PET) adhesive film.

It shall be understood that the first encapsulation adhesive film and the second encapsulation adhesive film have a boundary before lamination processing, and the photovoltaic module formed after the lamination processing does not have the so-called first encapsulation adhesive film and second encapsulation adhesive film, that is, the first encapsulation adhesive film and the second encapsulation adhesive film have formed the integral encapsulation adhesive film 27.

In some embodiments, the at least one cover plate 28 may be a cover plate having a light-transmitting function, such as a glass cover plate and a plastic cover plate. Specifically, a surface of the cover plate 28 facing the encapsulation adhesive film 27 may be a concave-convex surface, thereby increasing the utilization rate of incident light. The at least one cover plate 28 includes a first cover plate and a second cover plate, the first cover plate faces the first encapsulation adhesive film, and the second cover plate faces the second encapsulation adhesive film. Alternatively, the first cover plate faces one side of the solar cell and the second cover faces the other side of the solar cell.

In some embodiments, the photovoltaic module further includes at least one electrical connection wire. The edge electrode is electrically connected with the n₁ first main busbars of one solar cell of two adjacent solar cells, and the electrical connection wire is electrically connected with the edge electrode, such that the electrical connection wire is electrically connected with second main busbars of the other solar cell of the two adjacent solar cells. Alternatively, the edge electrode is electrically connected with the n₂ second main busbars of one solar cell of two adjacent solar cells, and the electrical connection wire is electrically connected with the edge electrode, such that the electrical connection wire is electrically connected with first main busbars of the other solar cell of the two adjacent solar cells. In this way, the electrical connection wire can be used to realize the interconnection between the two solar cells, thereby improving the yield of the photovoltaic modules and effectively avoiding the reduction of yield caused by pseudo soldering of one of the connecting members.

Specifically, for the first situation, since the edge electrode is electrically connected with the n₁ first main busbars of one solar cell of two adjacent solar cells, and the first main busbar of the one solar cell is electrically connected with the second main busbar of the other solar cell of the two adjacent solar cells, the edge electrode is electrically connected with the second main busbar of the other solar cell of the two adjacent solar cells. In addition, since the electrical connection wire is electrically connected with the edge electrode, the electrical connection wire is electrically connected with the second main busbar of the other solar cell of the two adjacent solar cells. For the technical details in the second situation, reference may be made to the first situation, which will not be described herein.

Embodiments of the disclosure provide another photovoltaic module. The photovoltaic module includes conductive structures, and each conductive structure is located between two adjacent solar cells. The conductive structure includes a first surface and a second surface which are opposite to each other. The first surface is in contact with the surface of each of the two solar cells, the second surface is electrically connected with the connecting members, and the connecting member is electrically connected with the first main busbar or the connecting member is electrically connected with the second main busbar. In this way, with aid of the conductive structures and the connecting members, the electrical connection between the first main busbars or the second main busbars of the solar cell, which can ensure that the first main busbars and each of the first finger electrodes are in a state of mutual conduction, thereby avoiding the situation that the efficiency and yield of the cells are reduced due to the damage of one of the first main busbars. Similarly, the cell efficiency can be improved by improving the cell collection efficiency of the second finger electrodes. In addition, since the electrodes in the solar cell are all in a conduction state, the problem of poor appearance between each of the first main busbars and corresponding first finger electrodes due to different preparation processes can be avoided. The interconnection between the first main busbars and the interconnection between the second main busbars can also avoid the problem of reduced cell efficiency due to broken of one of the finger electrodes or main busbars.

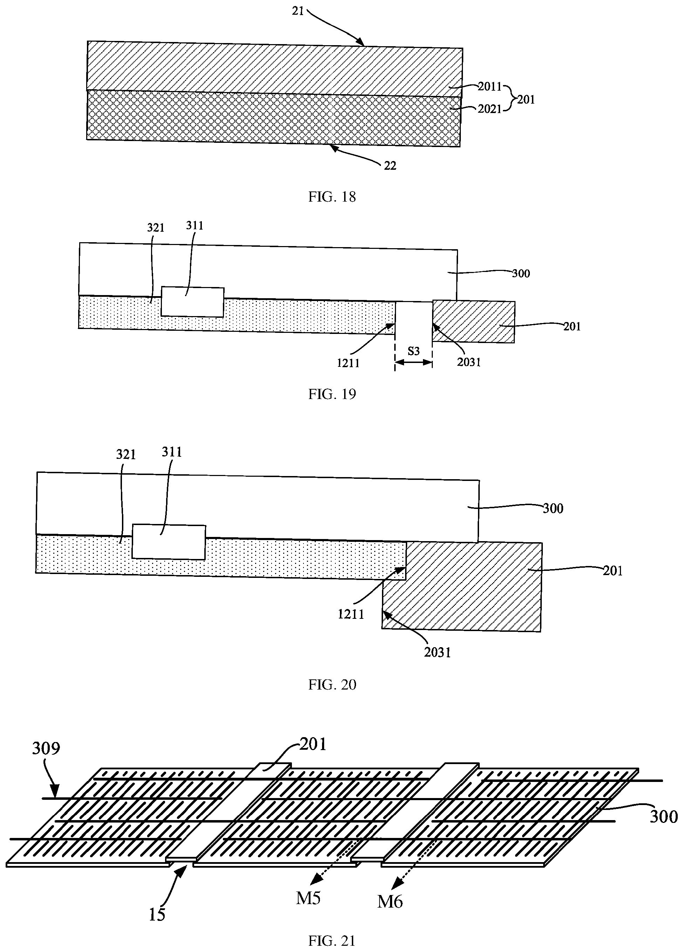

Referring to FIGS. 10 to 14, embodiments of the present disclosure provide a photovoltaic module. The photovoltaic module includes cell strings, where each cell string is formed by electrically connecting a plurality of solar cells 300 through connecting members 309. The solar cell 300 includes first main busbars 321 and second main busbars 322 that are disposed on a same surface of the solar cell, and each connecting member 309 is used for electrically connecting a first main busbar 321 of one solar cell 300 of two adjacent solar cells 300 and a second main busbar 322 of the other solar cell 300 of the two adjacent solar cells 300. The first main busbar 321 is one of a positive electrode or a negative electrode, and the second main busbar 322 is the other of the positive electrode or a negative electrode. The photovoltaic module further includes conductive structures 201, where each conductive structure 201 is disposed between two adjacent solar cells 300. The conductive structure 201 has a first surface 21 and a second surface 22 (referring to FIG. 18) that are disposed opposite to each other. The first surface 21 is in contact with a surface of each of the solar cells 300, and the second surface 22 is electrically connected with connecting members 309. The photovoltaic module further includes at least one encapsulation adhesive film 17 for covering surfaces of each cell string and a surface of each conductive structure 201; and at least one cover plate 18 for covering a surface of each encapsulation adhesive film 17 facing away from the cell strings.

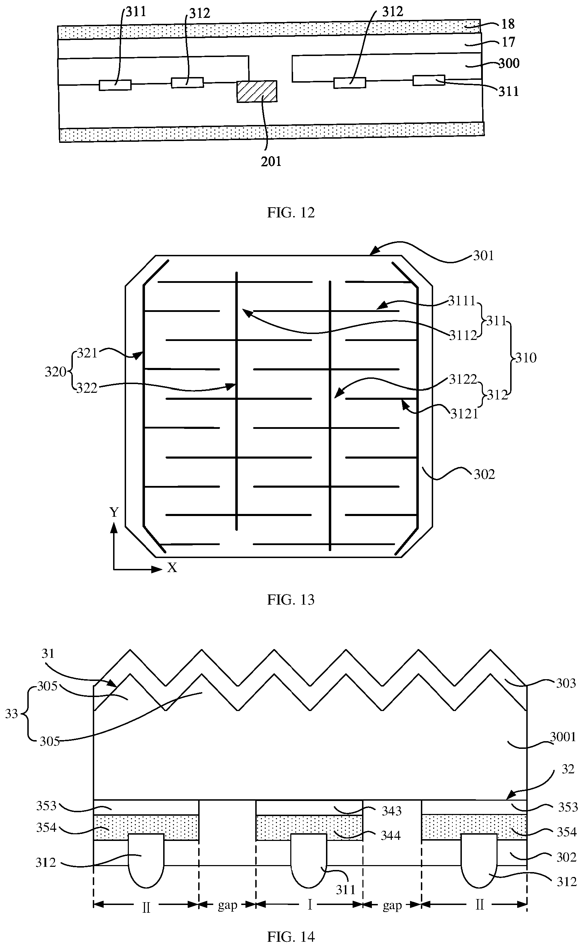

In some embodiments, referring to FIG. 13, the solar cell 300 is a back-contact solar cell.

Referring to FIG. 14, the solar cell includes a substrate 3001 having a first surface 31 and a first surface 32 that are disposed opposite to each other.

In some embodiments, for a material and a type of the doping element of the substrate 3001, reference may be made to the substrate 100 described above.

Similarly, the substrate 3001 has a first surface 31 and a second surface 32 opposite the first surface 31. The structure of the first surface 31 and the second surface 32 are similar to that of the first surface 11 and the second surface 12, which are not described herein. For example, the first surface 31 has a first textured structure 33. The first textured structure 33 includes a plurality of protrusion structures 305.

Similarly, the substrate 3001 has first regions I and second regions II that are alternatingly arranged. The first region I is one of a P region and an N region and the second region II is the other of the P region and the N region. Each P region and an adjacent N region are spaced by a spacing region *gap* therebetween. The solar cell includes finger electrodes 310 arranged in a first direction Y and each finger electrode 110 extends in a second direction X. The finger electrodes 310 includes rows of first finger electrodes 311 and rows of second finger electrodes 312 alternatingly arranged in the first direction Y. Each row of first finger electrodes 311 includes a corresponding set of first sub-electrodes arranged at intervals in the second direction X, and each row of second finger electrodes 312 includes a corresponding set of second sub-electrodes arranged at intervals in the second direction X. Each row of first finger electrodes 311 is between two adjacent rows of second finger electrodes 312. A respective row of first finger electrodes 311 is disposed in a corresponding first region I and a respective row of second finger electrodes 312 is disposed in a corresponding second region II.

Similarly, there is also no spacing region *gap* between each P region and the adjacent N region and achieving insulation between the first finger electrodes 311 and the second finger electrodes 312 can be achieved through an insulating film layer between each P region and the adjacent N region.

In some embodiments, referring to FIG. 14, the spacing region *gap* is flush with the P region and the N region. The spacing region *gap* being flush with the P region and the N region means that a height difference between the spacing region *gap* and the P region and the N region is within 1µm. Alternatively, the spacing region *gap* is lower than the P region and the spacing region *gap* is lower than the N region, that is, the second surface has grooves at the spacing regions *gap.* For the details of the spacing region *gap,* reference may be made to the above embodiments of the disclosure, which is not repeated herein.

In some embodiments, the solar cell further includes first dielectric layers 343 and first doped semiconductor layers 344. A respective first dielectric layer 343 and a respective first doped semiconductor layer 344 are formed over a corresponding first region I. The solar cell further includes second dielectric layers 353 and second doped semiconductor layers 354. A respective second dielectric layer 353 and a respective second doped semiconductor layer 354 are formed over a corresponding second region II. The passivation layer 302 is formed over the first doped semiconductor layers 344 and the second doped semiconductor layers 354, the respective row of first finger electrodes 311 penetrates the passivation layer 302 to be electrically connected with the respective first doped semiconductor layer 344, and the respective row of second finger electrodes 312 penetrates the passivation layer 302 to be electrically connected with the respective second doped semiconductor layer 354. That is, a respective row of first finger electrodes 311 is formed over and electrically connected with a portion of the respective first doped semiconductor layer 344 in a corresponding first region, and a respective row of second finger electrodes 312 is formed over and electrically connected with a portion of the respective second doped semiconductor layer 354 in a corresponding second region. The passivation layer 302 is formed over the spacing regions *gap* and over a portion of each first doped semiconductor layer 344 not under the row of first finger electrodes 311 and over a portion of each second doped semiconductor layer 154 not under the row of first finger electrodes 312. The rows of first finger electrodes 311 and the rows of second finger electrodes 312 together serve as the finger electrodes 310. A respective first main busbar 321 is electrically connected with a portion of each row of rows of first finger electrodes 311, a respective second main busbar 322 is electrically connected with a portion of each row of rows of second finger electrodes 312, and the first main busbar 321 and the second main busbars 322 together serve as the main busbars 320.

In some embodiments, for the details of the first doped semiconductor layer 344, the first dielectric layer 343, the second dielectric layer 353, and the second doped semiconductor layer 354, reference may be made to the first doped semiconductor layer 144, the first dielectric layer 143, the second dielectric layer 153, and the second doped semiconductor layer 154 in the above embodiments, which are not repeated herein.

In some embodiments, the solar cell may include a first intrinsic dielectric layer over the second surface, a first doped amorphous silicon layer, and a first transparent conductive layer that are sequentially disposed on the first region I. The solar cell may further include a second intrinsic dielectric layer over the second surface, a second doped amorphous silicon layer, and a second transparent conductive layer that are sequentially disposed on the second region II. The first doped amorphous silicon layer is doped with one of an N-type doping element and a P-type doping element, and the second doped amorphous silicon layer is doped with the other of an N-type doping element and a P-type doping element.

With continued reference to FIG. 14, the solar cell further includes a front passivation layer 303 formed over the front surface of the substrate 3001.

In some embodiments, for a material and structure of the front passivation layer 303 and the passivation layer 302, reference may be made to the front passivation layer 103 and the passivation layer 102.

In some embodiments, the first finger electrodes 311 and the second finger electrodes 312 are made of burn-through pastes, where the first finger electrode 311 burns through the passivation layer 302 to be electrically connected with the first doped semiconductor layer 344, and the second finger electrode 312 burns through the passivation layer 302 to be electrically connected with the second doped semiconductor layer 354.

For example, the first finger electrodes 311 are formed as follows. A metal paste is printed on a portion of a surface of the passivation layer 302 using a screen-printing process. The metal paste may include at least one of silver, aluminum, copper, tin, gold, lead, or nickel.

With continued reference to FIG. 13, each of the first finger electrodes 311 and the second finger electrodes 312 extends in the second direction X, and the first direction Y and the second direction X may be perpendicular to each other, or may have an angle of less than 90° therebetween, for example, 60°, 45°, 30°, and the like, as long as the first direction Y and the second direction X may not be in the same direction.

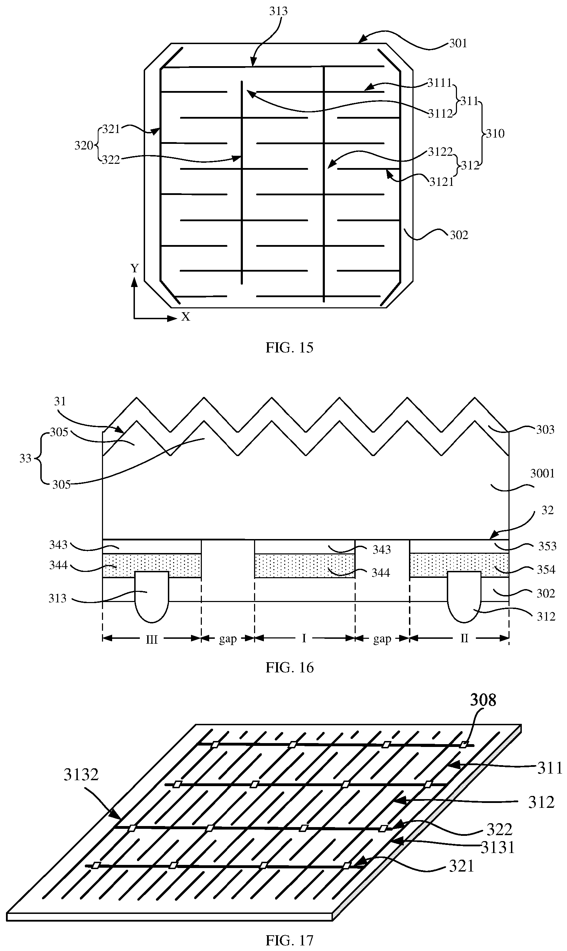

In some embodiments, referring to FIGS. 15 and 16, the solar cell further includes: m₁ first main busbars 321 and m₂ second main busbars 322 arranged alternatingly, and at least one edge electrode 313. The first main busbars 321 are formed over the at least one edge electrode 313, and an edge electrode 313 is electrically connected with n₁ first main busbars 321, where 1 < n₁ ≤ m₁. In some embodiments, providing the at least one edge electrode 313 may increase the collection rate of current generated by the substrate at the first boundary 301. In addition, providing the edge electrode 313 to be electrically connected with the first main busbars can realize the electrical connection between all the first finger electrodes 311 and the first main busbars 321, thereby improving the cell collection rate and reducing the cell defective rate.

In some embodiments, providing the edge electrode 313 can achieve the similar technical advantages as providing the edge electrode 113. For the detailed content of the edge electrode 313, reference may be made to the above edge electrode 113, which are not repeated herein for sake of simplicity.

In some embodiments, the edge electrode 313 includes a same material as the finger electrodes 310. The edge electrode 313 has the same paste as the paste of the finger electrodes 310. That is, the edge electrode 313 is made of a burn-through paste, and the edge electrode 313 also penetrates the passivation layer to be electrically connected with a corresponding first doped semiconductor layer. Therefore, the edge electrode 313 can not only realize the current penetration of the first main busbars 321, but also collect the current of the surface adjacent to the first boundary 301 of the substrate, thereby increasing the collection path and improving efficiency of the current collection.

In some embodiments, the paste of the edge electrode 313 is the same as that of the main busbar 320, i.e., the edge electrode 313 is made of a non-burn-through paste, and the edge electrode 313 is located on the surface of the passivation layer. In this way, the first regions I and II on the surface of the substrate below the edge electrode 313 may not need to be typeset to avoid short circuit caused by the electrical contact between the edge electrode 313 and the doped region of another polarity. In addition, the edge electrode 313 may not damage to the passivation layer, thereby ensuring integrity of the film layer of the passivation layer, improving the passivation effect of the passivation layer on the substrate, facilitating the reduction of optical loss of the solar cell, and improving the photoelectric conversion efficiency of the solar cell. In addition, since the non-burn-through paste has no excessive glass powder to damage the PN junction, the metal recombination can be effectively reduced, the open-circuit voltage of the solar cell can be improved, and the conversion efficiency of the solar cell can be improved.

In some embodiments, referring to FIG. 13, each row of first finger electrodes 311 includes first sub-electrodes 3111 arranged in the second direction X, and part of the passivation layer between each two adjacent first sub-electrodes 3111 forms a first spacer region 3112. That is, each row of first finger electrodes 311 includes a corresponding set of first sub-electrodes spaced from each other by a plurality of first spacer regions 3112 in the second direction X such that each pair of adjacent first sub-electrodes 3111 in the row of first finger electrodes 311 are separated by a corresponding first spacer region 3112 of the first spacer regions 3112. A respective second main busbar 322 is disposed on a corresponding first spacer region 3112. A respective first main busbar 321 is electrically connected with a corresponding first sub-electrode 3111 of each row of first finger electrodes 311. Each row of second finger electrodes 312 includes second sub-electrodes 3121 arranged in the second direction X, and part of the passivation layer between each two adjacent second sub-electrodes 3121 forms a second spacer region 3122. That is, each row of second finger electrodes 312 includes a corresponding set of second sub-electrodes spaced from each other by a plurality of second spacer regions 3122 in the second direction X such that each pair of adjacent second sub-electrodes 3121 in the row of second finger electrodes 312 are separated by a corresponding second spacer region 3122 of the second spacer regions 3122. A respective first main busbar 321 is disposed on a corresponding second spacer region 3122. A respective second main busbar 322 is electrically connected with a corresponding second sub-electrode 3121 of each row of second finger electrodes 312.

In some embodiments, a width of the edge electrode 313 in the first direction Y is greater than or equal to a width W2 of the finger electrode 310 in the first direction Y. The width of the finger electrode 310 in the first direction Y may be at least one of a width of the first finger electrode 311 in the first direction Y or a width of the second finger electrode 312 in the second direction Y. Therefore, the edge electrode 313 has a large width to realize the electrical connection between the first main busbars 321, and the edge electrode 313 does not have excessive influence on the arrangement of the original electrodes. When the width of the edge electrode 313 is equal to the width of the finger electrode 310, the edge electrode 313 can be prepared concurrently with the finger electrode 310 without affecting the original process, thereby improving the compatibility of the original device and the apparatus, and reducing the preparation cost of the solar cell.

In some embodiments, the width of the edge electrode 313 is greater than the width of the finger electrode 310, such that the wider edge electrode 313 may increase the collection area and the collection probability at the edge near the first boundary 301, thereby improving the cell collection efficiency. The wider edge electrode 313 can also be used as the end point of the first main busbar close to the first boundary, and the wider edge electrode 313 can improve the accuracy of the first main busbar overlapping on the edge electrode 313. Since the edge electrode can share the welding pressure of the first main busbar, the first main busbar 321 can also be correspondingly set to be shorter. That is, an end of the first main busbar 321 facing the first boundary 301 can be flush with or lower than a side of the edge electrode 313 facing the first boundary 301, so that a distance between a welding point of the ribbon and the first main busbar 321 and the first boundary 301 is set to be relatively farther, thereby reducing the probability of damage of the cell.

In some embodiments, the width of the edge electrode 313 in the first direction Y ranges from 10µm to 55µm. The width of the edge electrode 313 in the first direction Y may be 10µm ~ 16µm, 16µm ~ 22µm, 22µm ~ 30µm, 30µm ~ 38µm, 38µm ~ 46µm, or 46µm ~ 55µm. When the width of the edge electrode 313 in the first direction is within any of the above-mentioned ranges, the edge electrode 313 has a strong ability to collect carriers at the edge, and the edge electrode 313 has a certain distance from the first boundary 301, thereby reducing the probability of damage at the first boundary.

In some embodiments, the edge electrode 313 is spaced from an adjacent finger electrode 310 (where "adjacent" means that there is no other electrodes between the edge electrode 313 and adjacent finger electrode 310) by a first pitch, and the first pitch is less than or equal to a distance between each first finger electrode 311 and an adjacent second finger electrode 312 (where "adjacent" means that there is no other electrodes between the first finger electrode 311 and the second finger electrode 312). Thus, the pitch between the edge electrode 313 and the finger electrode 310 is appropriate, and the layout between the edge electrode 313 and the finger electrodes 310 can achieve a minimum carrier migration distance and a minimum migration loss on the substrate in a layout without wasting the shielding areas of the edge electrodes 313 and the finger electrode 310, thereby increasing the open circuit voltage of the solar cell.

It is to be noted that the first pitch in the embodiments of the present disclosure refers to a spacing between an axis of the edge electrode and an axis of the adjacent finger electrode, and there is no restriction on the first pitch in the embodiments of the present disclosure. For example, the first pitch can also be a distance between a side of the edge electrode facing the first boundary and the side of the adjacent finger electrode facing away from the first boundary or a shortest distance between the edge electrode and the adjacent finger electrode.

In some embodiments, the first pitch ranges from 0.2 mm to 0.7 mm. The first distance is in a range of 0.2 mm ~ 0.35 mm, 0.35 mm ~ 0.46 mm, 0.46 mm ~ 0.58 mm, 0.58 mm ~ 0.63 mm, or 0.63 mm ~ 0.7 mm.

In some embodiments, the distance between each first finger electrode 311 and the adjacent second finger electrode 312 ranges from 0.3 mm to 0.8 mm. The distance between the first finger electrode 311 and the second finger electrode 312 that are adjacent to each other ranges from 0.3 mm to 0.35 mm, 0.35 mm to 0.43 mm, 0.43 mm to 0.5 mm, 0.5 mm to 0.58 mm, 0.58 mm to 0.66 mm, 0.66 mm to 0.72 mm, or 0.72 mm to 0.8 mm.

In some embodiments, the substrate 3001 further has at least one third region III, and the at least one third region III is located at the edge of the substrate 100. The third region III has the same characteristics as an adjacent first region I or has the same characteristics as an adjacent second region II. For example, as shown in FIG. 16, the third region III and the first region I are adjacent to each other and have a spacing region *gap* between the third region III and the first region I, the third region III and the first region I have a same polarity. For example, if the first region I is an N region, the third region III is also an N region. In some embodiments, the polarity of the third region III is different from that of the first region I. For example, if the first region I is an N region, the third region III is a P region, such that the edge electrode located on the third region III is electrically connected with the second main busbars.

In some embodiments, arrangement of film layers on the third region III is the same as arrangement of film layers on the first region I, i.e., there are a first dielectric layer and a first doped semiconductor layer on a corresponding third region III. The edge electrode is electrically connected with the first doped semiconductor layer after penetrating the passivation layer. In other embodiments, arrangement of film layers on the third region III is the same as the arrangement of the film layers on the second region II, i.e., the solar cell has a second dielectric layer and a second doped semiconductor layer on the third region III, and the edge electrode is electrically connected with the second doped semiconductor layer after penetrating the passivation layer.

As illustrated in FIG. 17, the at least one edge electrode 313 is configured as two edge electrodes 313. One edge electrode 313 is electrically connected with n₁ first main busbars 321 and the other edge electrode 313 is electrically connected with n₂ second main busbars 322, where 1 < n₂ ≤ m₂, and n₁, m₁, n₂ and m₂ are all natural numbers.

In some embodiments, the at least one edge electrode 313 includes a first edge electrode 3131 and a second edge electrode 3132. The first edge electrode 3131 is disposed between the first boundary and the second finger electrode 312 (or first finger electrode 311), and the first edge electrode 3131 is electrically connected with the first main busbars. The second edge electrode 3132 is disposed between the other first boundary and the first finger electrode 111 (or second finger electrode 312), and the second edge electrode 3132 is electrically connected with the second main busbar. According to the embodiments of the present disclosure, two edge electrodes 313 are arranged at two first boundaries to realize interconnection between the first main busbars and interconnection between the second main busbars, thereby improving the collection efficiency and the yield of the solar cells.

In some embodiments, providing the first edge electrode 3131 to be electrically connected with the first main busbars and providing the second edge electrode 3132 to be electrically connected with the second main busbars can improve the collection efficiency of the solar cell by 3% ~ 10%, and reduce the defective rate of the cell by less than 8%.

In some embodiments, one edge electrode 313 is electrically connected with the n₁ first main busbars 321, and the other edge electrode 313 is electrically connected with n₂ second main busbars 322, where 1 < n₁ < m₁, and 1 < n₂ < m₂. At least one connection electrode for connecting the remaining first main busbars and/or the remaining second main busbars is located inside the cell, and the connection electrodes can achieve the electrical connection between the remaining first main busbars 321 and the electrical connection between the remaining second main busbars 322. Therefore, with aid of the edge electrodes 313 and the connection electrodes, the electrical connection between the first main busbars 321 and the first finger electrodes 311 in the solar cell and the electrical connection between the second main busbars 322 and the second finger electrodes 312 in the solar cell can be achieved.

In some embodiments, m₁ ≥ 8, and m₂ ≥ 8, for example the number of first main busbars may be 8, the number of second main busbars may be 8, and the number of main busbars may be 16.

In some embodiments, the number of the first main busbars may be a natural number greater than 8 and the number of the second main busbars may be a natural number greater than 8.

Furthermore, the photovoltaic module includes the conductive structures, where each conductive structure is disposed between two solar cells, the conductive structure includes the first surface and the second surface which are opposite to each other, the first surface is in contact with a surface of each the two solar cells, and the second surface is electrically connected with the connecting members, and the connecting member is electrically connected with the first main busbar or the connecting member. In this way, with aid of the conductive structures and the connecting members, the electrical connection between the first main busbars or the second main busbars of the solar cell, which can ensure that the first main busbars and each of the first finger electrodes are in a state of mutual conduction, thereby avoiding the situation that the efficiency and yield of the cells are reduced due to the damage of one of the first main busbars. Similarly, the cell efficiency can be improved by improving the cell collection efficiency of the second finger electrodes.

In addition, since the electrodes in the solar cell are all in a conduction state, the problem of poor appearance between each of the first main busbars and corresponding first finger electrodes due to different preparation processes can be avoided. The interconnection between the first main busbars and the interconnection between the second main busbars can also avoid the problem of reduced cell efficiency due to broken of one of the main busbars.

In some embodiments, referring to FIG. 10, there is a gap 15 between each two adjacent solar cells 300, and the conductive structure 201 is partially located in the gap 15. A length of the gap 15 along an arrangement direction of the solar cells ranges from 0mm ~ 3mm. The length of the gap 15 along the arrangement direction of the solar cells can be in a range of 0 mm ~ 0.8 mm, 0.8 mm ~ 1.3 mm, 1.3 mm ~ 1.7 mm, 1.7 mm ~ 2.4 mm, or 2.4 mm ~ 3mm.

In some embodiments, the solar cell 300 is in a stacked state with the adjacent solar cell 300, i.e. a partial region of each solar cell 300 near the first boundary is located below the adjacent solar cell. A length of an overlapping region between each two adjacent solar cells 300 ranges from 0mm to 1mm. For example, the length of the overlapping region between each two adjacent solar cells 300 is in the range of 0 mm to 0.3 mm, 0.3 mm to 0.7 mm, or 0.7 mm to 1mm.

In some embodiments, a ratio of an area of an overlapping region between the first surface 21 and the solar cell 300 to a surface area of the first surface 21 ranges from 1/10 to 1. For example, the ratio of the area of the overlapping region between the first surface 21 and the solar cell 300 to the surface area of the first surface 21 ranges from 1/10 to 0.35, 0.35 to 0.5, 0.5 to 0.67, 0.67 to 0.83, or 0.83 to 1. That is, the conductive structure 201 is at least partially located on the solar cell 300, and the area of part of the conductive structure 201 on the solar cell 300 is set within a suitable value, such that the conductive structure 201 can be fixed on the solar cell 300 without large movement, thereby ensuring the contact performance between the conductive structure 201 and the connecting member 309, and further improving the yield and collection efficiency of the photovoltaic module.

In some embodiments, the conductive structure 201 has a length of 2mm to 9mm along the arrangement direction of the solar cells 300. The length of the conductive structure along the arrangement direction of the solar cells 300 ranges from 2mm to 3.8 mm, 3.8 mm to 5mm, 5mm to 6.9 mm, 6.9 mm to 7.8 mm, or 7.8 mm to 9mm. When the length of the conductive structure 201 along the arrangement direction of the solar cells 300 is within any of the above-mentioned ranges, the conductive structure 201 can realize the performance of electrically connecting two adjacent solar cells 300. The conductive structure 201 is located in the gap 15, and the conductive structure 201 can be located on part of the surface of the solar cells, so that the contact performance between the connecting member and the conductive structure is good, and the connecting member and the conductive structure are abutted against each other, thereby reducing the contact resistance between the connecting member and the conductive structure.

In some embodiments, the collection efficiency of the solar cells can be improved by 3% ~ 8% and the defective rate of the cells can be reduced by less than 6% by providing the conductive structure to be electrically connected with the connecting member.

In some embodiments, referring to FIG. 18, the conductive structure 201 includes an insulating layer 2021 and a conductive layer 2011. The insulating layer 2021 has one side in contact with one side of the conductive layer 2011 and has the other side constituting the first surface 21, and the conductive layer 2011 has the other side constituting the second surface 22.

In some embodiments, the conductive layer 2011 is used to achieve an electrical connection between different connecting members 309 for electrically connecting the two adjacent solar cells. The insulating layer 2021 is used to ensure mutual insulation between the conductive structure 201 and the cells, thereby avoiding a short circuit between the first main busbars and the second main busbars of the solar cell.

In some embodiments, a material of the insulating layer includes: polyethylene (PE), ethylene-vinyl acetate copolymer (EVA), or polyethylene terephthalate (PET). A material of the conductive layer includes aluminum, aluminum tin, or copper.

In some embodiments, the insulating layer includes an adhesive layer, which can achieve mutual fixation between the conductive structure and the solar cell, thereby preventing the conductive structure from shifting when the encapsulation adhesive film is not encapsulated, and avoiding affecting the yield of the photovoltaic module.

In some embodiments, a material of the adhesive layer is the same as the material of the at least one encapsulation adhesive film. In this way, the adhesive layer can achieve mutual fusion with the encapsulation adhesive film in the laminating process, that is, there is no adhesive layer in the photovoltaic module. Compared with the solutions in which the adhesive layer and the encapsulation adhesive film include different materials, the adhesive layer and the encapsulation adhesive film including same materials can reduce bubbles and gaps in the photovoltaic module, and then improve the yield of the photovoltaic modules. In addition, the material of the adhesive layer is the same as that of the encapsulation adhesive film, which can also improve the encapsulation effect of the photovoltaic module, thereby prolonging the service life of the photovoltaic module.

In some embodiments, with reference to FIG. 11 or FIG. 12, each solar cell has solder pads 308 for effecting soldering between the connecting members 309 and the main busbars.

In some embodiments, the photovoltaic module further includes an insulating film which may have a same property of the insulating film 206, which are not repeated herein.

In some embodiments, referring to FIG. 12, the photovoltaic module does not include the insulating film, and the conductive structure is located on the surface of the solar cell. The conductive structure has an insulating layer and a conductive layer. In FIG. 12, the conductive structure is not in contact with the main busbars. It shall be understood that the conductive structure may be located on the main busbars or a side of the conductive structure is in contact with a side of each of at least one main busbar. The main busbars include the first main busbars and the second main busbars.

Referring to FIG. 19, in some embodiments, the conductive structure 201 has a first edge 2031 facing the first main busbars in the first direction and extending in the second direction, the first main busbar 321 has a second edge 1211 facing the conductive structure in the first direction and extending in the second direction, and a distance S3 between the first edge 2031 and the second edge 1211 ranges from 0mm to 2mm. The plurality of solar cells are arranged in the first direction.

In some embodiments, the conductive structure is a laminated structure, i.e., the conductive structure includes the insulating layer and the conductive layer. In some embodiments, the conductive structure is a conductive layer, and a first surface of the conductive layer is the first surface of the conductive structure, and a second surface of the conductive layer is a second surface of the conductive structure.

In some embodiments, referring to FIGS. 17 and 20, the second main busbar 322 is spaced from the first edge 2031 by a distance greater than 0, i.e., the conductive structure and the second main busbar 322 are insulated from each other. The conductive structure includes the conductive layer. The conductive layer has a first surface and a second surface that are disposed opposite to each other. The configuration of the second main busbar 322 is not schematically illustrated in FIG. 20 and only the positional relationship between the first main busbar and the conductive structure is illustrated.

In some embodiments, referring to FIG. 20, the first edge 2031 is in contact with the first main busbar 321. Thus, the first main busbar is in direct contact with the conductive structure. Therefore, the first main busbar is in contact with the conductive layer for electrical connection, and the connecting member is in contact with the second surface for electrical connection, so that a current collection path of the cell may include a path from the first main busbar to the conductive structure, and finally to the connecting member, i.e., the current from the first main busbar to the connecting member through the solder pads. The scheme can increase the carrier collection path, thereby improving the collection efficiency of the photovoltaic module.

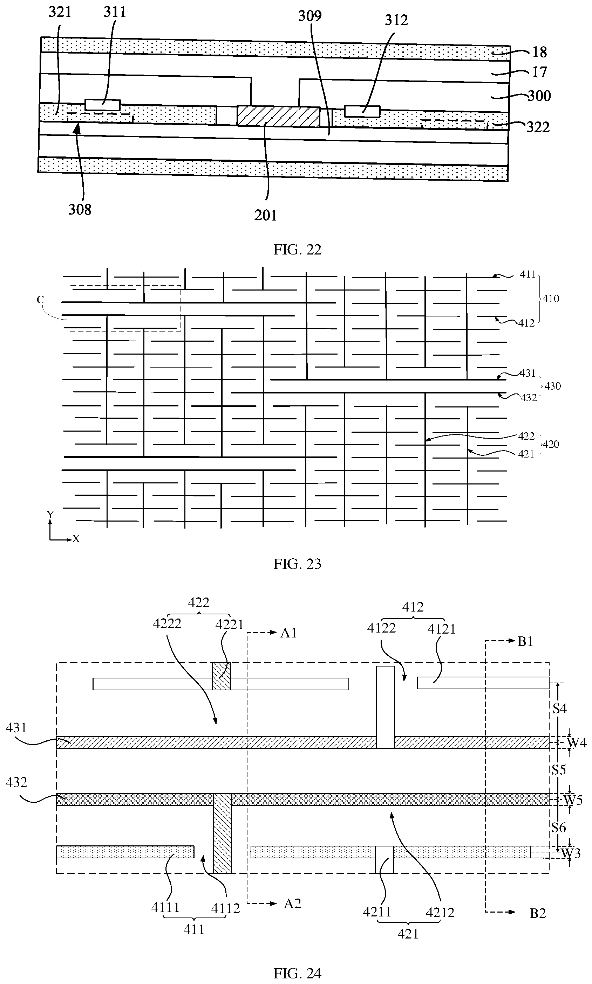

In some embodiments, referring to FIGS. 21 and 22, two opposite sides of the first surface 21 in the first direction are respectively in contact with the surfaces of two adjacent solar cells.

In some embodiments, the at least one encapsulation adhesive film 17 and the at least one cover plate 18 may be made of a material and property same as that of the encapsulation adhesive film 27 and the cover plate 28, and thus for the sake of concise, which are not repeated herein.

In some embodiments, the photovoltaic module further includes at least one electrical connection wire. The edge electrode is electrically connected with the n₁ first main busbars of one solar cell of two adjacent solar cells, and the electrical connection wire is electrically connected with the edge electrode, such that the electrical connection wire is electrically connected with second main busbars of the other solar cell of the two adjacent solar cells, and the first surface is electrically connected with the electrical connection wire. Alternatively, the edge electrode is electrically connected with the n₂ second main busbars of one solar cell of two adjacent solar cells, and the electrical connection wire is electrically connected with the edge electrode, such that the electrical connection wire is electrically connected with first main busbars of the other solar cell of the two adjacent solar cells. In this way, the electrical connection wire can be used to realize the interconnection between the two solar cells, thereby improving the yield of the photovoltaic modules and effectively avoiding the reduction of yield caused by pseudo soldering of one of the connecting members. For the specific technical details of the electrical connection wire, reference may be made to the above embodiments of the disclosure, which are not described herein.

Embodiments of the present disclosure further provide a solar cell. Referring to FIGS. 23 to 25, the solar cell includes a substrate 400 and a passivation layer 402 formed over a surface of the substrate 400. The solar cell includes finger electrodes 410 arranged in a first direction Y and each finger electrode 410 extends in a second direction X, and the finger electrodes 410 penetrate the passivation layer 402 to be electrically connected with the substrate 400, the finger electrodes 410 including rows of first finger electrodes 411 and rows of second finger electrodes 412 alternatingly arranged in the first direction Y. Each row of first finger electrodes 411 is between two adjacent rows of second finger electrodes 412. The solar cell further includes main busbars 420 arranged in the second direction X, and the main busbars 420 are formed over the passivation layer 402. A respective main busbar 420 is electrically connected with a portion of each of corresponding finger electrodes 410. The main busbars 420 include m₁ first main busbars 421 and m₂ second main busbars 422 arranged alternatingly along the second direction X. A respective first main busbar 421 is electrically connected with a portion of each row of rows of first finger electrodes 411, and a respective second main busbar 422 is electrically connected with a portion of each row of rows of second finger electrodes 412. The respective first main busbar 421 is one of a positive electrode and a negative electrode, and the respective second main busbar 422 is the other of the positive electrode and the negative electrode. The solar cell further includes at least two first connection electrodes 431. The at least two first connection electrodes 431 penetrate the passivation layer 402 to be electrically connected to the substrate 400. One of the at least two first connection electrodes 431 is electrically connected with n₁ adjacent first main busbars 421, where 1 < n₁ < m₁. The solar cell further includes at least two second connection electrodes 432 penetrating the passivation layer 402 to be electrically connected to the substrate 400, where one of the at least two second connection electrodes 432 is electrically connected with n₂ adjacent second main busbars 422, where 1 < n₂ < m₂.

In some embodiments, each row of first finger electrodes 411 includes a corresponding set of first sub-electrodes arranged at intervals in the second direction X, and each row of second finger electrodes 412 includes a corresponding set of second sub-electrodes arranged at intervals in the second direction X. A respective first main busbar 421 is electrically connected with a respective first sub-electrode of each row of rows of first finger electrodes 411, and a respective second main busbar 422 is electrically connected with a respective second sub-electrode of each row of rows of second finger electrodes 412.

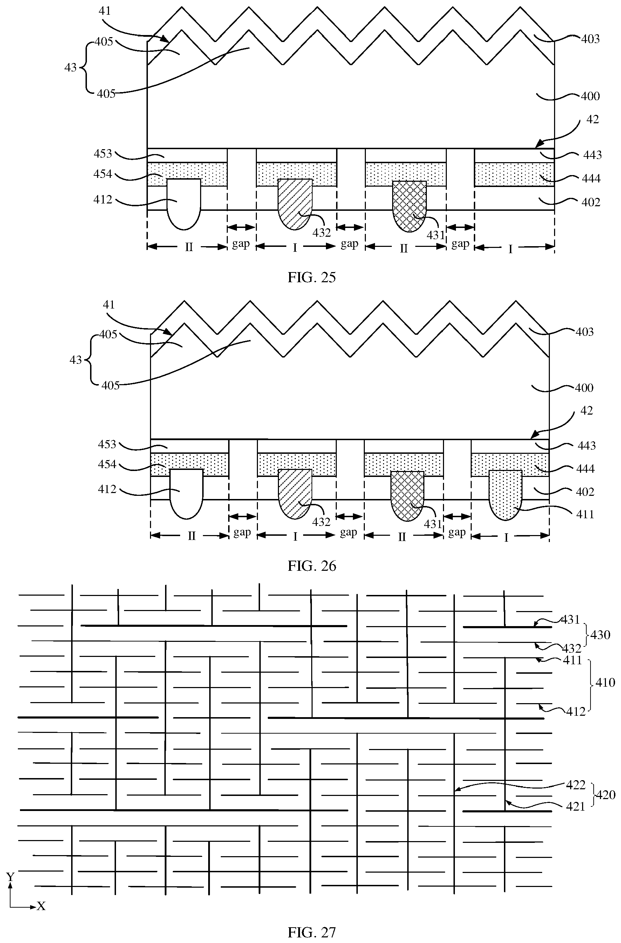

In some embodiments, referring to FIG. 25, the solar cell is a back-contact solar cell.

For a material and a type of the doping element of the substrate 400, reference may be made to the substrate 100 or the substrate 3001 described above.

Similarly, the substrate 400 has a first surface 41 and a second surface 42 opposite the first surface 41. In some embodiments, the first surface 41 has a first textured structure 43. The first textured structure 43 includes a plurality of protrusion structures 405.

Similarly, the substrate 400 also has first regions I and second regions II that are alternatingly arranged in the first direction Y.

In some embodiments, referring to FIG. 25, the spacing region *gap* is flush with the P region and the N region. Alternatively, the spacing region *gap* is lower than the P region and the spacing region *gap* is lower than the N region. For the details of the spacing region *gap,* reference may be made to the above embodiments of the disclosure, which is not repeated herein.

In some embodiments, the solar cell further includes first dielectric layers 443 and first doped semiconductor layers 444. A respective first dielectric layer 443 and a respective first doped semiconductor layer 444 are formed over a corresponding first region I. The solar cell further includes second dielectric layers 453 and second doped semiconductor layers 454. A respective second dielectric layer 453 and a respective second doped semiconductor layer 454 are formed over a corresponding second region II. The passivation layer 402 is formed over the first doped semiconductor layers 444 and the second doped semiconductor layers 454, the respective row of first finger electrodes 411 penetrates the passivation layer 402 to be electrically connected with the respective first doped semiconductor layer 444, and the respective row of second finger electrodes 412 penetrates the passivation layer 402 to be electrically connected with the respective second doped semiconductor layer 454. That is, a respective row of first finger electrodes 411 is formed over and electrically connected with a portion of the respective first doped semiconductor layer 444 in a corresponding first region, and a respective row of second finger electrodes 412 is formed over and electrically connected with a portion of the respective second doped semiconductor layer 454 in a corresponding second region. The passivation layer 402 is formed over the spacing regions *gap* and over a portion of each first doped semiconductor layer 444 not under the row of first finger electrodes 411 and over a portion of each second doped semiconductor layer 454 not under the row of first finger electrodes 412.

In some embodiments, for the details of the first doped semiconductor layer 444, the first dielectric layer 443, the second dielectric layer 453, and the second doped semiconductor layer 454, reference may be made to the first doped semiconductor layer 144/344, the first dielectric layer 143/343, the second dielectric layer 153/353, and the second doped semiconductor layer 154/354 in the above embodiments, which are not repeated herein.

In some embodiments, the solar cell may include a first intrinsic dielectric layer, a first doped amorphous silicon layer, and a first transparent conductive layer on the first region I. The solar cell may further include a second intrinsic dielectric layer, a second doped amorphous silicon layer, and a second transparent conductive layer on the second region II.

With continued reference to FIGS. 25 and 26, the solar cell further includes a front passivation layer 403 formed over the front surface of the substrate 400.

In some embodiments, for the details of the front passivation layer 403 and the passivation layer 402, reference may be made to the front passivation layer 103/303 and the passivation layer 102/302, which are not repeated herein.

In some embodiments, the first finger electrodes 411, the second finger electrodes 412, and the at least two connection electrodes 430 are all prepared as burn-through pastes. The first finger electrode 411 burns through the passivation layer 402 to be electrically connected with the first doped semiconductor layer 444, and the second finger electrode 412 burns through the passivation layer 402 to be electrically connected with the second doped semiconductor layer 454. The at least two connection electrodes 430 burn through the passivation layer 402 to be electrically connected with the first doped semiconductor layer 444, and/or the at least two connection electrodes 430 burn through the passivation layer 402 to be electrically connected with the second doped semiconductor layer 454. The at least two connection electrodes 430 include a first connection electrode 431 and a second connection electrode 432. The first connection electrode 431 is electrically connected with the first doped semiconductor layer 444 after penetrating the passivation layer 402, and the second connection electrode 432 is electrically connected with the second doped semiconductor layer 454 after penetrating the passivation layer 402.

For example, the first finger electrodes 411 are formed similar to the first finger electrodes 311/111.

With continued reference to FIG. 23, each of the first finger electrodes 411 and the second finger electrodes 412 extends in the second direction X, and the first direction Y and the second direction X may be perpendicular to each other, or may have an angle of less than 90° therebetween, for example, 60°, 45°, 30°, and the like, as long as the first direction Y and the second direction X may not be in the same direction.

In some embodiments, the connection electrode 430 includes a same material as the finger electrodes 410. The connection electrode 430 has the same paste as the finger electrodes 410, i.e., the connection electrode 430 is made of a burn-through paste, and the connection electrode 430 also penetrates the passivation layer to be electrically connected with the corresponding first doped semiconductor layer or the corresponding second doped semiconductor layer. Thus, the connection electrode 430 can not only realize the current penetration of the first main busbars 421 and the current penetration of the second main busbars 422, but also can collect the current on the surface of the substrate, thereby increasing the collection path and improving the current collection efficiency.

In some embodiments, a material of the first connection electrode 431 is the same as a material of the finger electrodes 410. A material of the second connection electrode 432 is the same as that of the finger electrodes 410.

In some embodiments, the paste of the connection electrode 430 is the same as that of the main busbar 420, i.e., the connection electrode 430 is made of a non-burn-through paste, and the connection electrode 430 is located on the surface of the passivation layer. In this way, the first regions I and II on the surface of the substrate below the connection electrode 430 may not need to be typeset to avoid short circuit caused by the electrical contact between the connection electrode 430 and the doped region of another polarity. In addition, the connection electrode 430 may not damage to the passivation layer, thereby ensuring integrity of the film layer of the passivation layer, improving the passivation effect of the passivation layer on the substrate, facilitating the reduction of optical loss of the solar cell, and improving the photoelectric conversion efficiency of the solar cell. In addition, since the non-burn-through paste has no excessive glass powder to damage the PN junction, the metal recombination can be effectively reduced, the open-circuit voltage of the solar cell can be improved, and the conversion efficiency of the solar cell can be improved.

The conventional paste includes a mixture of metal powder, glass powder, and an organic carrier. The non-burn-through paste refers to the paste containing lower glass powder content than that the conventional paste, having a weak burn-through capability in the sintering process, and not required or able to burn the paste of the passivation layer. The burn-through paste refers to the paste having a strong burn-through capability and able to burn through the passivation layer in the sintering process.

In some embodiments, the collection efficiency of the solar cell can be increased by 1% to 5% and the defective rate of the cell can be reduced by less than 5% by providing the first connection electrode to electrically connect first main busbars and providing the second connection electrode to electrically connect second main busbars, thereby improving the photoelectric conversion efficiency of the solar cell and the high cost-effectiveness of the photovoltaic modules.

In some embodiments, referring to FIG. 24, each row of first finger electrodes 411 includes first sub-electrodes 4111 arranged in the second direction X, and part of the passivation layer between each two adjacent first sub-electrodes 4111 defines a first spacer region 4112. That is, each row of first finger electrodes 411 includes a corresponding set of first sub-electrodes spaced from each other by a plurality of first spacer regions 4112 in the second direction X such that each pair of adjacent first sub-electrodes 4111 in the row of first finger electrodes 411 are separated by a corresponding first spacer region 4112 of the first spacer regions 4112. A respective second main busbar 422 is disposed on a corresponding first spacer region 4112. A respective first main busbar 421 is electrically connected with a corresponding first sub-electrode 4111 of each row of the first sub-electrodes 4111. Each row of second finger electrodes 412 includes second sub-electrodes 4121 arranged in the second direction X, and a part of the passivation layer between each two adjacent second sub-electrodes 4121 defines a second spacer region 4122. That is, each row of second finger electrodes 412 includes a corresponding set of second sub-electrodes spaced from each other by a plurality of second spacer regions 4122 in the second direction X such that each pair of adjacent second sub-electrodes 4121 in the row of second finger electrodes 412 are separated by a corresponding second spacer region 4122 of the second spacer regions 4122. A respective first main busbar 421 is disposed on a corresponding second spacer region 4122. A respective second main busbar 422 is electrically connected with a corresponding second sub-electrode 4121 of each row of second finger electrodes 412.

In some embodiments, referring to FIG. 24, each respective first main busbar 421 includes a plurality of first sub-main busbars 4211 spaced from each other by a plurality of first disconnection regions 4212 in the first direction Y such that each pair of adjacent first sub-main busbars 4211 in the respective first main busbar 421 are separated by a corresponding first disconnection region 4212 of the plurality of first disconnection regions 4212. Part of the passivation layer between two adjacent first sub-main busbars 4211 defines the first disconnection region 4212. The first connection electrode 431 is electrically connected with a corresponding first sub-main busbar 4211 of each of at least two adjacent first main busbars 421. Each respective second main busbar 422 includes a plurality of second sub-main busbars 4221 spaced from each other by a plurality of second disconnection regions 4222 in the first direction Y such that each pair of adjacent second sub-main busbars 4221 in the respective second main busbar 422 are separated by a corresponding second disconnection region 4222 of the plurality of second disconnection regions 4222. Part of the passivation layer between two adjacent second sub-main busbars 4221 defines the second disconnection region 4222. The second connection electrode 432 is electrically connected with a corresponding second sub-main busbar 4221 of each of at least two adjacent second main busbars 422.

In some embodiments, referring to FIGS. 23, 27, and 28, the first disconnection region 4212 is disposed adjacent to the second disconnection region 4222 in the second direction X. The second connection electrode 432 is further located in the first disconnection regions 4212, and the first connection electrode 431 is further located in the second disconnection regions 4222. Each second connection electrode 432 is disposed between a first sub-main busbar 4211 and a corresponding first connection electrode 431.

Referring to FIG. 23, the solar cell includes two first connection electrodes 431, where the two first connection electrodes 431 penetrate the passivation layer 402 to be electrically connected to the substrate 400. One of the two first connection electrodes 431 is electrically connected to n₁ adjacent first main busbars 421, where n₁= (1/2) m₁. The solar cell further includes two second connection electrodes 432, where the two second connection electrodes 432 penetrate the passivation layer 402 to be electrically connected to the substrate 400. One of the two second connection electrodes 432 is electrically connected to n₂ adjacent second main busbars 422, where n₂= (1/2) m₂.

In some embodiments, typeset of electrodes shown in FIG. 23 can improve the collection efficiency of solar cells by 1% ~ 6%, and reduce the defective rate of cells by less than 3.5%.

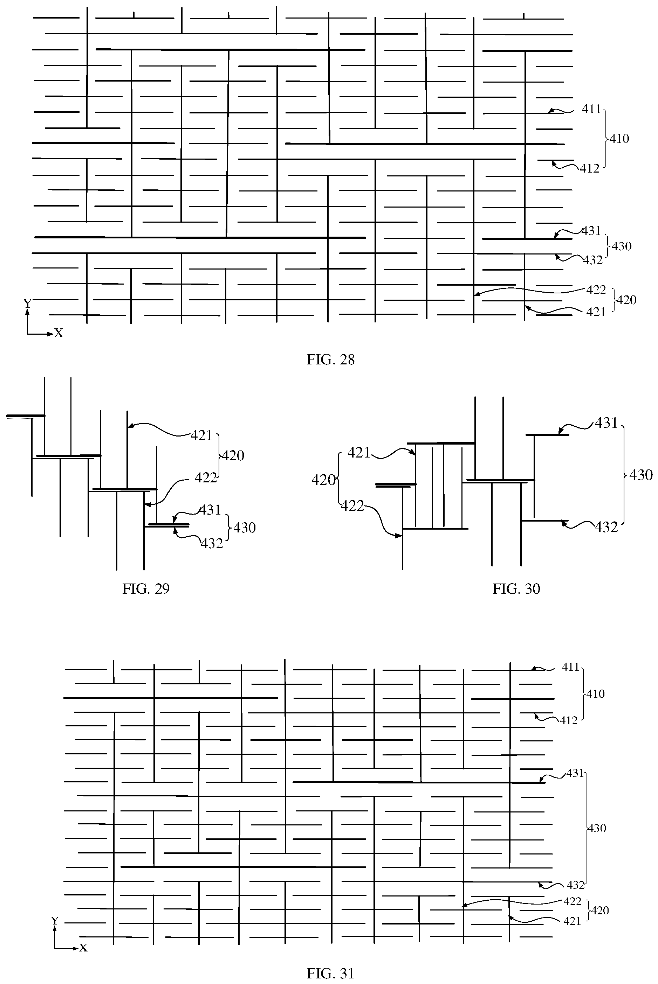

Referring to FIG. 27 or FIG. 28, the number of first connection electrodes 431 in the solar cell is greater than two, the first connection electrodes 431 penetrating the passivation layer 402 to be electrically connected to the substrate 400. One of the first connection electrodes 431 is electrically connected with n₁ adjacent first main busbars 421, where n₁ < (1/2) m₁. The number of second connection electrodes 432 in the solar cell is greater than two, and the second connection electrodes 432 penetrate the passivation layer 402 to be electrically connected to the substrate 400, where one of the second connection electrodes 432 is electrically connected to n₂ adjacent second main busbars 422, where n₂ < (1/2) m₂.

In some embodiments, typeset of electrodes shown in FIG. 27 can improve the collection efficiency of solar cells by 2% ~ 5.8%, and reduce the defective rate of cells by less than 6%.

In some embodiments, typeset of electrodes shown in FIG. 28 can improve the collection efficiency of solar cells by 2% ~ 6.3%, and reduce the defective rate of cells by less than 5.5%.

In some embodiments, referring to FIGS. 27 and 29, the first connection electrodes 431 are arranged in a staggered manner in the first direction Y, and the second connection electrodes 432 are arranged in a staggered (misaligned) manner in the first direction Y.

In some embodiments, referring to FIGS. 25 and 30, the first connection electrodes 431 are arranged in a stepped manner in the first direction Y, and the second connection electrodes 432 are arranged in a stepped manner in the first direction Y.

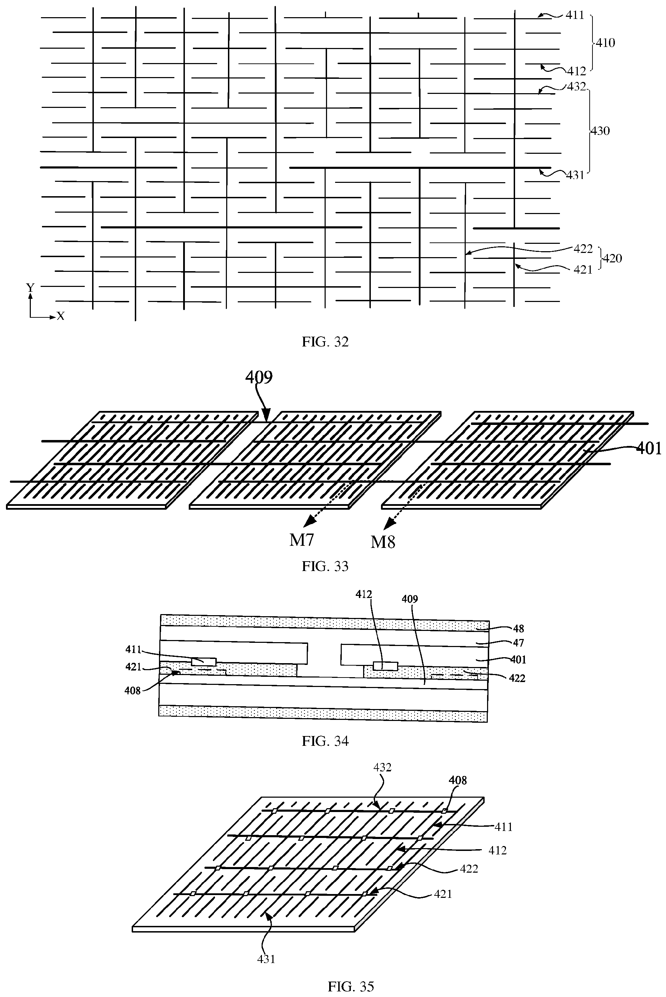

In some embodiments, referring to FIGS. 31 and 32, part of the passivation layer 402 between two adjacent second sub-main busbars 4221 defines the second disconnection region 4222. The first connection electrode 431 is located in the second disconnection region 4222 and electrically connected with two adjacent first main busbars 421. Part of the passivation layer 402 between two adjacent first sub-main busbars 4211 defines the first disconnection region 4212. The second connection electrode 432 is located in the first disconnection region 4212 and electrically connected with two adjacent second main busbars 422.

The arrangement of the first connection electrodes 431 and the second connection electrodes 432 in FIG. 31 is shown in FIG. 29, and the arrangement of the first connection electrodes 431 and the second connection electrodes 432 in FIG. 32 are shown in FIG. 30.

In some embodiments, typeset of electrodes shown in FIG. 31 can increase the collection efficiency of solar cells by 3% ~ 8%, and reduce the defective rate of cells by less than 7%.

In some embodiments, typeset of electrodes shown in FIG. 32 can improve the collection efficiency of solar cells by 2% ~ 7.8%, and reduce the defective rate of cells by less than 6%.

In some embodiments, a width of each connection electrode 430 is greater than a width of a respective finger electrode 410. For example, referring to FIG. 24, a width W4 of the first connection electrode 431 in the first direction Y is greater than or equal to a width W3 of the finger electrode 410. A width W5 of the second connection electrode 432 in the first direction Y is greater than or equal to the width W3 of the finger electrode 410. Therefore, the wider connection electrode 430 can improve the collection area and the collection efficiency.

In some embodiments, the width W4 of the first connection electrode 431 in the first direction Y ranges from 10µm to 55µm. The width W4 of the first connection electrode 431 in the first direction Y may be in a range of 10µm ~ 16µm, 16µm ~ 22µm, 22µm ~ 30µm, 30µm ~ 38µm, 38µm ~ 46µm, or 46µm ~ 55µm.

In some embodiments, the width W5 of the second connection electrode 432 in the first direction Y ranges from 10µm to 55µm. The width W5 of the second connection electrode 432 in the first direction may be in a range of 10µm ~ 16µm, 16µm ~ 22µm, 22µm ~ 30µm, 30µm ~ 38µm, 38µm ~ 46µm, or 46µm ~ 55 µm.

In some embodiments, the first connection electrode 431 is spaced from an adjacent finger electrode 410 by a first distance S4, and the first distance S4 is less than or equal to a distance between each first finger electrode 411 and an adjacent second finger electrode 412. Therefore, the spacing between the first connection electrode 431 and the finger electrode 410 is more appropriate, and the layout between the first connection electrodes 431 and the finger electrodes 410 can achieve a minimum carrier migration distance and a minimum migration loss on the substrate in a layout without wasting the shielding areas of the first connection electrode 431 and the finger electrode 410, thereby increasing the open circuit voltage of the solar cell.

It is to be noted that the first distance in FIG. 24 of the embodiments of the present disclosure refers to a spacing between an axis of the first connection electrode 431 and an axis of the adjacent finger electrode, and there is no restriction on the first distance in the embodiments of the present disclosure. For example, the first distance can also be a distance between a side of the first connection electrode 431 facing the boundary of the substrate and the side of the adjacent finger electrode facing away from the boundary of the substrate or a shortest distance between the first connection electrode 431 and the adjacent finger electrode 410.

In some embodiments, the first distance S4 ranges from 0.2 mm to 0.7 mm. The first distance S4 is in the range of 0.2 mm ~ 0.35 mm, 0.35 mm ~ 0.46 mm, 0.46 mm ~ 0.58 mm, 0.58 mm ~ 0.63 mm, or 0.63 mm ~ 0.7 mm.

In some embodiments, the distance between each first finger electrode 411 and an adjacent second finger electrode 412 ranges from 0.3 mm to 0.8 mm. For example, the distance between each first finger electrode 411 and the adjacent second finger electrode 412 ranges from 0.3 mm to 0.35 mm, 0.35 mm to 0.43 mm, 0.43 mm to 0.5 mm, 0.5 mm to 0.58 mm, 0.58 mm to 0.66 mm, 0.66 mm to 0.72 mm, or 0.72 mm to 0.8 mm.

Similarly, the second connection electrode 432 is spaced from an adjacent finger electrode 410 by a third distance S6, and the third distance S3 is less than or equal to the distance between the adjacent first finger electrode 411 and the adjacent second finger electrode 412. The third distance S6 ranges from 0.2 mm to 0.7 mm.

In some embodiments, the first connection electrode 431 is spaced from the second connection electrode 432 by a second distance S5, and the second distance S5 is less than or equal to the distance between each first finger electrode 411 and the adjacent second finger electrode 412. The second distance S5 ranges from 0.2 mm to 0.7 mm.

In some embodiments, m₁ ≥ 8, and m₂ ≥ 8, for example, the number of first main busbars may be 8, the number of second main busbars may be 8, and the number of main busbars may be 16.

In some embodiments, the number of the first main busbars may be a natural number greater than 8 and the number of the second main busbars may be a natural number greater than 8.

In the solar cell of the embodiments of the present disclosure, by providing at least two first connection electrodes 431, the interconnection between the first main busbars 421 can be achieved. Using one electrode can connect busbars (e.g., positive electrodes or negative electrodes) of the same polarity in the solar cell in series, i.e., one solar cell forms an integral electrode, thus ensuring that each first main busbar 421 and each first finger electrode 411 to be in a state of mutual conduction, thereby avoiding the probability that the efficiency and yield of the cells are reduced due to damage of one of the first main busbars 421. In addition, current collected by the first finger electrode 411 located at the edge of the substrate can be collected due to conduction of each first finger electrode 411, thus improving the collection efficiency of the cell. Similarly, the cell efficiency can be improved by improving the cell collection efficiency of the second finger electrodes 412.

The solar cell provided by the embodiments of the present disclosure can ensure that the first main busbars 421 and the first finger electrodes 411 are in a state of mutual conduction, and can avoid the problem of poor appearance between the first main busbars 421 and the first finger electrodes 411 due to different preparation processes. The interconnection between the first main busbars 421 can also avoid the problem of the decrease of the cell efficiency due to broken of one of the finger electrodes or the main busbar, thereby improving the cell efficiency. Providing the at least two second connection electrodes 432 may also improve the cell efficiency of the second finger electrodes 412 and the second main busbars 422.

In addition, compared with a solution in which using one connection electrode to connect the plurality of first main busbars 421 or second main busbars 422, in the present disclosure, by providing two connection electrodes to connect the plurality of first main busbars 421 or the second main busbars 422, it is possible to avoid broken of the electrodes caused by over-long electrodes and large influence on the first main busbars 421 and the second main busbars 422 due to over-long electrodes, thereby improving the cell yield.

Correspondingly, another aspect of the embodiment of the present disclosure further provides a photovoltaic module. The photovoltaic module may include the solar cell provided in the above embodiments, and has the same or corresponding technical features as the above embodiment, which will not be described in detail herein.

Referring to FIGS. 33 to 35, embodiments of the present disclosure further provide a photovoltaic module. The photovoltaic module includes a plurality of cell strings each formed by connecting a plurality of solar cells 401 described in any of the above embodiments. The solar cell 401 includes first main busbars 421, and second main busbars 422 on a same surface of the solar cell. The photovoltaic module further includes connecting members 409, where each connecting member 409 is used for electrically connecting a first main busbar 421 of one solar cell of two adjacent solar cells and a second main busbar 422 of the other solar cell of two adjacent solar cells; at least one encapsulation adhesive film 47 for covering surfaces of each cell string; and at least one cover plate 48 for covering a surface of each encapsulation adhesive film 47 facing away from the cell strings.

In some embodiments, the plurality of cell strings may be electrically connected with each other through the connecting members 409, where each of the connecting members 409 is electrically connected with corresponding main busbars on the cells. For example, each connecting member has an end electrically connected with a first main busbar of a first cell, and has the other end electrically connected with a second main busbar of a second cell adjacent to the first cell.

In some embodiments, no spacing is provided between the cells, i.e., the cells overlap each other.

In some embodiments, the connecting members are electrically connected with finger electrodes on the cells.

In some embodiments, with reference to FIG. 35, each solar cell has solder pads 408 for effecting soldering between the connecting members 409 and the main busbars.

In some embodiments, referring to FIG. 34, the photovoltaic module further includes an insulating film 406. For the details of the insulating film 406, reference may be made to the insulating film 206, which are not repeated herein.

In some embodiments, for the details of the at least one encapsulation adhesive film 47 and the at least one cover plate 48, reference may be made to the encapsulation adhesive film 27/17 and cover plate 28/18, which are not repeated herein.

In some embodiments, the photovoltaic module further includes at least one electrical connection wire. The electrical connection wire electrically connects a first main busbar of a solar cell of two adjacent solar cells with a second main busbar of the other solar cell of the two adjacent solar cells. Alternatively, the electrical connection wire electrically connects a second main busbar of a solar cell of two adjacent solar cells with a first main busbar of the other solar cell of the two adjacent solar cells. In this way, the electrical connection wire can be used to realize the interconnection between the two solar cells, thereby improving the yield of the photovoltaic modules and effectively avoiding the reduction of yield caused by pseudo soldering of one of the connecting members.

It is to be noted that similar elements in the embodiments of the disclosure having the same/similar functions may be labeled by the same or different reference numbers, for example, the solar cell may be denoted as 300 and 401, the substrate may be denoted as 3001 and 400, and the like, which are not described herein. It is to be noted that although some components/members employ different terminologies, the positions and functions of the components/members are similar, and details of the various embodiments can be implemented in cooperation with each other without conflicting.

When a certain part "includes" another part throughout the specification, other parts are not excluded unless otherwise stated, and other parts may be further included. In addition, when parts such as a layer, a film, a region, or a plate is referred to as being "on" another part, it may be "directly on" another part or may have another part present therebetween. In addition, when a part of a layer, film, region, plate, etc., is "directly on" another part, it means that no other part is positioned therebetween.

In the drawings, the thickness of layers and an area has been enlarged for better understanding and ease of description. When it is described that a part, such as a layer, film, area, or substrate, is "over" or "on" another part, the part may be "directly" on another part or a third part may be present between the two parts. In contrast, when it is described that a part is "directly on" another part, it means that a third part is not present between the two parts. Furthermore, when it is described that a part is "generally" formed on another part, it means the part is not formed on the entire surface (or front surface) of another part and is also not formed in part of the edge of the entire surface.

In addition, the terms "adjacent" means there is no other electrode between the two, what are the two are next to each other in a row was sequence or arrangement. For example, A and B are two of the electrodes in the arrangement of electrodes, and A is adjacent to B means there is no other electrode between A and B, or A and B are next to each other in the arrangement.

The terminology used in the description of the various described embodiments herein is for the purpose of describing particular embodiments only and is not intended to be limiting. As used in the description of the various described embodiments and the appended claims, the singular forms "a", "an" and "the" are intended to include the plural forms as well, unless the context clearly indicates otherwise.

## Claims

1. A solar cell, comprising:
a substrate (100, 3001, 400) having two opposite first boundaries each extending in a first direction;
a passivation layer (302, 402) formed over the substrate (100, 3001, 400);
finger electrodes (310, 410) formed over the substrate (100, 3001, 400) between the two opposite first boundaries, each finger electrode of the finger electrodes (310, 410) extending in the first direction, wherein the finger electrodes (310, 410) include rows of first finger electrodes (311, 411) and rows of second finger electrodes (312, 412) alternatingly arranged in a second direction, the first direction and the second direction intersect with each other, and each row of first finger electrodes (311, 411) is between two adjacent rows of second finger electrodes (312, 412), and wherein the finger electrodes (310, 410) penetrate the passivation layer to be electrically connected with the substrate (100, 3001, 400);
main busbars (120, 320, 420) formed over the passivation layer (302, 402), the main busbars (120, 320, 420) including m₁ first main busbars (121, 321, 421) and m₂ second main busbars (122, 322, 422) alternatingly arranged in the first direction, a respective first main busbar (121, 321, 421) extending in the second direction and being electrically connected with a portion of each row of the rows of first finger electrodes (311, 411), and a respective second main busbar (122, 322, 422) extending in the second direction and being electrically connected with a portion of each row of the rows of second finger electrodes (312, 412), and wherein the respective first main busbar (121, 321, 421) is one of a positive electrode and a negative electrode, and the respective second main busbar (122, 322, 422) is the other of the positive electrode and the negative electrode; wherein
at least one edge electrode (113, 313) extending in the first direction, wherein a respective edge electrode of the at least one edge electrode (113, 313) is between each of the finger electrodes (310, 410) and a corresponding first boundary of the two opposite first boundaries, and the respective edge electrode (113, 313) at least partially penetrating the passivation layer (302, 402) to be electrically connected with the substrate (100, 3001, 400), and wherein the at least one edge electrode (113, 313) includes at least one of:
a first edge electrode (1131, 3131) electrically connected with n₁ first main busbars (121, 321, 421); and
a second edge electrode (1132, 3132) electrically connected with n₂ second main busbars (122, 322, 422); **characterized in that** 1 < n₁ < m₁, 1 < n₂< m₂, n₁, m₁, n₂, and m₂ are natural numbers; and
at least one connection electrode (430) extending in the first direction in a non-edge region of the solar cell, wherein the connection electrode (430) penetrates the passivation layer (302, 402) to be electrically connected with the substrate (100, 3001, 400) and includes at least one first connection electrode (431) and at least one second connection electrode (432):
the at least one first connection electrode (431) is electrically connected with m₁-n₁ first main busbars (121, 321, 421) not connected to the first edge electrode (1131, 3131);
the at least one second connection electrode (432) is electrically connected with m₂-n₂ second main busbars (122, 322, 422) not connected to the second edge electrode (1132, 3132).

2. The solar cell of claim 1, wherein the respective edge electrode (113, 313) has a polarity same as a polarity of an adjacent finger electrode (310, 410), wherein there is no other finger electrode (310, 410) between the respective edge electrode (113, 313) and the adjacent finger electrode (310, 410).

3. The solar cell of any of claims 1 to 2, wherein a respective row of first finger electrodes (311, 411) includes first sub-electrodes (1111) spaced by first spacer regions (1112) in the first direction such that each pair of adjacent first sub-electrodes (1111) in the respective row of first finger (311, 411) electrodes are separated by a corresponding first spacer region of the first spacer regions (1112), a respective second main busbar (122, 322, 422) is disposed on a corresponding first spacer region (1112), and a respective first main busbar (121, 321, 421) is in electrical contact with a corresponding first sub-electrode (1111) of each row of first finger electrodes (311, 411); and
a respective row of second finger electrodes (312, 412) includes second sub-electrodes (1121) spaced by second spacer regions (1122) in the first direction such that each pair of adjacent second sub-electrodes (1121) in the respective row of second finger electrodes (312, 412) are separated by a corresponding second spacer region of the second spacer regions (1122), a respective first main busbar (121, 321, 421) is disposed on a corresponding second spacer region (1122), and a respective second main busbar (122, 322, 422) is in electrical contact with a corresponding second sub-electrode (1121) of each row of second finger electrodes (312, 412).

4. The solar cell of any of claims 1 to 3, wherein the respective edge electrode (113, 313) has a width in the second direction greater than or equal to a width of a respective finger electrode (310, 410) in the second direction.

5. The solar cell of claim 4, wherein the respective edge electrode (113, 313) has a width in the second direction ranging from 10µm to 55µm.

6. The solar cell of any of claims 1 to 5, wherein the respective edge electrode (113, 313) is spaced from the adjacent finger electrode (311, 411) by a first pitch, and the first pitch is less than or equal to a distance between a respective first finger electrode (311, 411) and an adjacent second finger electrode (312, 412).

7. The solar cell of claim 6, wherein the first pitch ranges from 0.2 mm to 0.7 mm.

8. The solar cell of claim 6, wherein the distance between the respective first finger electrode (311, 411) and the adjacent second finger electrode (312, 412) ranges from 0.3 mm to 0.8 mm.

9. The solar cell of any of claims 1 to 8, wherein the respective edge electrode (113, 313) and a respective finger electrode (310, 410) include a same material.

10. The solar cell of any of claims 1 to 9, wherein the at least one connection electrode (430) includes a material same as a material of the finger electrodes (310,410), and in the second direction, a respective connection electrode (430) of the at least one connection electrode (430) has a width greater than or equal to a width of a respective finger electrode of the finger electrodes.

11. A photovoltaic module, comprising:
at least one cell string each formed by connecting a plurality of solar cells, wherein each solar cell is the solar cell of any of claims 1 to 10;
a plurality of connecting members (409), wherein each connecting member (409) is configured to electrically connect the first main busbar (121, 321, 421) of one solar cell of two adjacent solar cells with the second main busbar (122, 322, 422) of another solar cell of the two adjacent solar cells;
at least one encapsulation adhesive film (17, 27, 47) each configured to cover a surface of a respective cell string; and
at least one cover plate (48) each configured to cover a surface of a respective encapsulation adhesive film (17, 27, 47) facing away from the at least one cell string.

12. The photovoltaic module of claim 11, further comprising at least one electrical connection wire, wherein the first edge electrode (1131, 3131) is electrically contacted with the n₁ first main busbars (121, 321, 421) of one solar cell of two adjacent solar cells, and a respective electrical connection wire is electrically connected with the one edge electrode (113, 313), such that the respective electrical connection wire is electrically connected with second main busbars (122, 322, 422) of the other solar cell of the two adjacent solar cells; and/or the second edge electrode (1132, 3132) is in electrical contact with the n₂ second main busbars (122, 322, 422) of the one solar cell of the two adjacent solar cells, and the respective electrical connection wire is electrically connected with the other edge electrode (113, 313), such that the respective electrical connection wire is electrically connected with first main busbars (121, 321, 421) of the other solar cell of the two adjacent solar cells.

## Patentansprüche

1. Solarzelle, umfassend:
ein Substrat (100, 3001, 400) mit zwei gegenüberliegenden ersten Rändern, die sich jeweils in einer ersten Richtung erstrecken;
eine Passivierungsschicht (302, 402), die über dem Substrat (100, 3001, 400) gebildet ist;
Fingerelektroden (310, 410), die auf dem Substrat (100, 3001, 400) zwischen den zwei gegenüberliegenden ersten Rändern gebildet sind, wobei sich jede Fingerelektrode der Fingerelektroden (310, 410) in der ersten Richtung erstreckt, wobei die Fingerelektroden (310, 410) Reihen von ersten Fingerelektroden (311, 411) und Reihen von zweiten Fingerelektroden (312, 412) umfassen, die abwechselnd in einer zweiten Richtung angeordnet sind, wobei sich die erste Richtung und die zweite Richtung schneiden, und jede Reihe von ersten Fingerelektroden (311, 411) zwischen zwei benachbarten Reihen von zweiten Fingerelektroden (312, 412) liegt, und wobei die Fingerelektroden (310, 410) die Passivierungsschicht durchdringen, um elektrisch mit dem Substrat (100, 3001, 400) verbunden zu sein;
Hauptsammelschienen (120, 320, 420), die über der Passivierungsschicht (302, 402) gebildet sind, wobei die Hauptsammelschienen (120, 320, 420) m₁ erste Hauptsammelschienen (121, 321, 421) und m₂ zweite Hauptsammelschienen (122, 322, 422) umfassen, die abwechselnd in der ersten Richtung angeordnet sind, wobei sich eine jeweilige erste Hauptsammelschiene (121, 321, 421) in der zweiten Richtung erstreckt und elektrisch mit einem Abschnitt jeder Reihe der Reihen von ersten Fingerelektroden (311, 411) verbunden ist, und eine jeweilige zweite Hauptsammelschiene (122, 322, 422) sich in der zweiten Richtung erstreckt und elektrisch mit einem Abschnitt jeder Reihe der Reihen von zweiten Fingerelektroden (312, 412) verbunden ist, und wobei die jeweilige erste Hauptsammelschiene (121, 321, 421) eine von einer positiven Elektrode und einer negativen Elektrode ist, und die jeweilige zweite Hauptsammelschiene (122, 322, 422) die andere von der positiven Elektrode und der negativen Elektrode ist; wobei
mindestens eine Randelektrode (113, 313) sich in der ersten Richtung erstreckt, wobei eine jeweilige Randelektrode der mindestens einen Randelektrode (113, 313) zwischen jeder der Fingerelektroden (310, 410) und einem entsprechenden ersten Rand der zwei gegenüberliegenden ersten Ränder liegt, und die jeweilige Randelektrode (113, 313) die Passivierungsschicht (302, 402) zumindest teilweise durchdringt, um elektrisch mit dem Substrat (100, 3001, 400) verbunden zu sein, und wobei die mindestens eine Randelektrode (113, 313) mindestens eine der folgenden umfasst:
eine erste Randelektrode (1131, 3131), die elektrisch mit n₁ ersten Hauptsammelschienen (121, 321, 421) verbunden ist; und
eine zweite Randelektrode (1132, 3132), die elektrisch mit n₂ zweiten Hauptsammelschienen (122, 322, 422) verbunden ist; **dadurch gekennzeichnet, dass** 1 < n₁ < m₁, 1 < n₂< m₂, n₁, m₁, n₂ und m₂ natürliche Zahlen sind; und
mindestens eine Verbindungselektrode (430), die sich in der ersten Richtung in einem Nicht-Randbereich der Solarzelle erstreckt, wobei die Verbindungselektrode (430) die Passivierungsschicht (302, 402) durchdringt, um elektrisch mit dem Substrat (100, 3001, 400) verbunden zu sein, und mindestens eine erste Verbindungselektrode (431) und mindestens eine zweite Verbindungselektrode (432) umfasst:
die mindestens eine erste Verbindungselektrode (431) ist elektrisch mit m₁-n₁ ersten Hauptsammelschienen (121, 321, 421) verbunden, die nicht mit der ersten Randelektrode (1131, 3131) verbunden sind;
die mindestens eine zweite Verbindungselektrode (432) ist elektrisch mit m₂-n₂ zweiten Hauptsammelschienen (122, 322, 422) verbunden, die nicht mit der zweiten Randelektrode (1132, 3132) verbunden sind.

2. Solarzelle nach Anspruch 1, wobei die jeweilige Randelektrode (113, 313) eine Polarität aufweist, die gleich einer Polarität einer benachbarten Fingerelektrode (310, 410) ist, wobei zwischen der jeweiligen Randelektrode (113, 313) und der benachbarten Fingerelektrode (310, 410) keine andere Fingerelektrode (310, 410) vorhanden ist.

3. Solarzelle nach einem der Ansprüche 1 bis 2, wobei eine jeweilige Reihe von ersten Fingerelektroden (311, 411) erste Unterelektroden (1111) umfasst, die durch erste Abstandsbereiche (1112) in der ersten Richtung beabstandet sind, sodass jedes Paar von benachbarten ersten Unterelektroden (1111) in der jeweiligen Reihe von ersten Fingerelektroden (311, 411) durch einen entsprechenden Abstandsbereich der ersten Abstandsbereiche (1112) getrennt ist, eine jeweilige zweite Hauptsammelschiene (122, 322, 422) auf einem entsprechenden ersten Abstandsbereich (1112) angeordnet ist, und eine jeweilige erste Hauptsammelschiene (121, 321, 421) in elektrischem Kontakt mit einer entsprechenden ersten Unterelektrode (1111) jeder Reihe von ersten Fingerelektroden (311, 411) steht; und
eine jeweilige Reihe von zweiten Fingerelektroden (312, 412) zweite Unterelektroden (1121) umfasst, die durch zweite Abstandsbereiche (1122) in der ersten Richtung beabstandet sind, sodass jedes Paar von benachbarten zweiten Unterelektroden (1121) in der jeweiligen Reihe von zweiten Fingerelektroden (312, 412) durch einen entsprechenden Abstandsbereich der zweiten Abstandsbereiche (1122) getrennt ist, eine erste Hauptsammelschiene (121, 321, 421) auf einem entsprechenden zweiten Abstandsbereich (1122) angeordnet ist, und eine jeweilige zweite Hauptsammelschiene (122, 322, 422) in elektrischem Kontakt mit einer entsprechenden zweiten Unterelektrode (1121) jeder Reihe von zweiten Fingerelektroden (312, 412) steht.

4. Solarzelle nach einem der Ansprüche 1 bis 3, wobei die jeweilige Randelektrode (113, 313) in der zweiten Richtung eine Breite aufweist, die größer oder gleich einer Breite einer jeweiligen Fingerelektrode (310, 410) in der zweiten Richtung ist.

5. Solarzelle nach Anspruch 4, wobei die jeweilige Randelektrode (113, 313) eine Breite in der zweiten Richtung aufweist, die von 10µm bis 55µm reicht.

6. Solarzelle nach einem der Ansprüche 1 bis 5, wobei die jeweilige Randelektrode (113, 313) von der benachbarten Fingerelektrode (311, 411) um einen ersten Abstand beabstandet ist, und der erste Abstand kleiner oder gleich einem Abstand zwischen einer jeweiligen ersten Fingerelektrode (311, 411) und einer benachbarten zweiten Fingerelektrode (312, 412) ist.

7. Solarzelle nach Anspruch 6, wobei der erste Abstand von 0,2 mm bis 0,7 mm reicht.

8. Solarzelle nach Anspruch 6, wobei der Abstand zwischen der jeweiligen ersten Fingerelektrode (311, 411) und der benachbarten zweiten Fingerelektrode (312, 412) von 0,3 mm bis 0,8 mm reicht.

9. Solarzelle nach einem der Ansprüche 1 bis 8, wobei die jeweilige Randelektrode (113, 313) und eine jeweilige Fingerelektrode (310, 410) ein gleiches Material umfassen.

10. Solarzelle nach einem der Ansprüche 1 bis 9, wobei die mindestens eine Verbindungselektrode (430) ein Material umfasst, das einem Material der Fingerelektroden (310, 410) gleicht, und in der zweiten Richtung eine jeweilige Verbindungselektrode der mindestens einen Verbindungselektrode (430) eine Breite aufweist, die größer oder gleich einer Breite einer jeweiligen Fingerelektrode der Fingerelektroden ist.

11. Photovoltaikmodul, umfassend:
mindestens eine Zellenkette, die jeweils durch Verbinden einer Vielzahl von Solarzellen gebildet ist, wobei jede Solarzelle die Solarzelle nach einem der Ansprüche 1 bis 10 ist;
eine Vielzahl von Verbindungselementen (409), wobei jedes Verbindungselement (409) dafür konfiguriert ist, die erste Hauptsammelschiene (121, 321, 421) einer Solarzelle von zwei benachbarten Solarzellen mit der zweiten Hauptsammelschiene (122, 322, 422) einer anderen Solarzelle der zwei benachbarten Solarzellen elektrisch zu verbinden;
mindestens eine Verkapselungsklebefolie (17, 27, 47), die jeweils dafür konfiguriert ist, eine Oberfläche einer jeweiligen Zellenkette zu bedecken; und
mindestens eine Abdeckplatte (48), die jeweils dafür konfiguriert ist, eine Oberfläche einer jeweiligen Verkapselungsklebefolie (17, 27, 47) zu bedecken, die von der mindestens einen Zellenkette abgewandt ist.

12. Photovoltaikmodul nach Anspruch 11, ferner umfassend mindestens einen elektrischen Verbindungsdraht, wobei die erste Randelektrode (1131, 3131) in elektrischem Kontakt mit den n₁ ersten Hauptsammelschienen (121, 321, 421) einer Solarzelle von zwei benachbarten Solarzellen steht, und ein jeweiliger elektrischer Verbindungsdraht elektrisch mit der einen Randelektrode (113, 313) verbunden ist, sodass der jeweilige elektrische Verbindungsdraht elektrisch mit zweiten Hauptsammelschienen (122, 322, 422) der anderen Solarzelle der zwei benachbarten Solarzellen verbunden ist; und/oder die zweite Randelektrode (1132, 3132) in elektrischem Kontakt mit den n₂ zweiten Hauptsammelschienen (122, 322, 422) der einen Solarzelle der zwei benachbarten Solarzellen steht, und der jeweilige elektrische Verbindungsdraht elektrisch mit der anderen Randelektrode (113, 313) verbunden ist, sodass der jeweilige elektrische Verbindungsdraht elektrisch mit ersten Hauptsammelschienen (121, 321, 421) der anderen Solarzelle der zwei benachbarten Solarzellen verbunden ist.

## Revendications

1. Cellule solaire, comprenant :
un substrat (100, 3001, 400) ayant deux premiers bords opposés s'étendant chacun dans une première direction ;
une couche de passivation (302, 402) formée sur le substrat (100, 3001, 400) ;
des électrodes en forme de doigt (310, 410) formées sur le substrat (100, 3001, 400) entre les deux premiers bords opposés, chaque électrode en forme de doigt des électrodes en forme de doigt (310, 410) s'étendant dans la première direction, dans lequel les électrodes en forme de doigt (310, 410) comprennent des rangées de premières électrodes en forme de doigt (311, 411) et des rangées de secondes électrodes en forme de doigt (312, 412) agencées en alternance dans une seconde direction, la première direction et la seconde direction se coupant l'une l'autre, et chaque rangée de premières électrodes en forme de doigt (311, 411) est entre deux rangées adjacentes de secondes électrodes en forme de doigt (312, 412), et dans lequel les électrodes en forme de doigt (310, 410) pénètrent la couche de passivation pour être connectées électriquement au substrat (100, 3001, 400) ;
des barres omnibus principales (120, 320, 420) formées sur la couche de passivation (302, 402), les barres omnibus principales (120, 320, 420) comprenant m₁ premières barres omnibus principales (121, 321, 421) et m₂ secondes barres omnibus principales (122, 322, 422) agencées en alternance dans la première direction, une première barre omnibus principale respective (121, 321, 421) s'étendant dans la seconde direction et étant connectée électriquement avec une partie de chaque rangée des rangées de premières électrodes en forme de doigt (311, 411), et une seconde barre omnibus principale respective (122, 322, 422) s'étendant dans la seconde direction et étant connectée électriquement avec une partie de chaque rangée des rangées de secondes électrodes en forme de doigt (312, 412), et dans lequel la première barre omnibus principale respective (121, 321, 421) est l'une d'une électrode positive et d'une électrode négative, et la seconde barre omnibus principale respective (122, 322, 422) est l'autre de l'électrode positive et de l'électrode négative ; dans laquelle
au moins une électrode de bord (113, 313) s'étendant dans la première direction, dans laquelle une électrode de bord respective de ladite au moins une électrode de bord (113, 313) est entre chacune des électrodes en forme de doigt (310, 410) et un premier bord correspondant des deux premiers bords opposés, et l'électrode de bord respective (113, 313) pénètre au moins partiellement la couche de passivation (302, 402) pour être connectée électriquement au substrat (100, 3001, 400), et dans laquelle ladite au moins une électrode de bord (113, 313) comprend au moins l'une de :
une première électrode de bord (1131, 3131) connectée électriquement avec n₁ premières barres omnibus principales (121, 321, 421) ; et
une seconde électrode de bord (1132, 3132) connectée électriquement avec n₂ secondes barres omnibus principales (122, 322, 422) ; **caractérisée en ce que** 1 < n₁ < m₁, 1 < n₂< m₂, n₁, m₁, n₂, et m₂ sont des nombres naturels ; et
au moins une électrode de connexion (430) s'étendant dans la première direction dans une région non-bord de la cellule solaire, dans laquelle l'électrode de connexion (430) pénètre la couche de passivation (302, 402) pour être connectée électriquement au substrat (100, 3001, 400) et comprend au moins une première électrode de connexion (431) et au moins une seconde électrode de connexion (432) :
ladite au moins une première électrode de connexion (431) est connectée électriquement avec mi-ni premières barres omnibus principales (121, 321, 421) non connectées à la première électrode de bord (1131, 3131) ;
ladite au moins une seconde électrode de connexion (432) est connectée électriquement avec m₂-n₂ secondes barres omnibus principales (122, 322, 422) non connectées à la seconde électrode de bord (1132, 3132).

2. Cellule solaire selon la revendication 1, dans laquelle l'électrode de bord respective (113, 313) a une polarité identique à une polarité d'une électrode en forme de doigt adjacente (310, 410), dans laquelle il n'y a pas d'autre électrode en forme de doigt (310, 410) entre l'électrode de bord respective (113, 313) et l'électrode en forme de doigt adjacente (310, 410).

3. Cellule solaire selon l'une quelconque des revendications 1 à 2, dans laquelle une rangée respective de premières électrodes en forme de doigt (311, 411) comprend des premières sous-électrodes (1111) espacées par des premières régions d'espacement (1112) dans la première direction de sorte que chaque paire de premières sous-électrodes adjacentes (1111) dans la rangée respective de premières électrodes en forme de doigt (311, 411) est séparée par une région de premières régions d'espacement correspondante des premières régions d'espacement (1112), une seconde barre omnibus principale respective (122, 322, 422) est disposée sur une première région d'espacement correspondante (1112), et une première barre omnibus principale respective (121, 321, 421) est en contact électrique avec une première sous-électrode correspondante (1111) de chaque rangée de premières électrodes en forme de doigt (311, 411) ; et
une rangée respective de secondes électrodes en forme de doigt (312, 412) comprend des secondes sous-électrodes (1121) espacées par des secondes régions d'espacement (1122) dans la première direction de sorte que chaque paire de secondes sous-électrodes adjacentes (1121) dans la rangée respective de secondes électrodes en forme de doigt (312, 412) est séparée par une région de secondes régions d'espacement correspondante des secondes régions d'espacement (1122), une première barre omnibus principale (121, 321, 421) est disposée sur une seconde région d'espacement correspondante (1122), et une seconde barre omnibus principale respective (122, 322, 422) est en contact électrique avec une seconde sous-électrode correspondante (1121) de chaque rangée de secondes électrodes en forme de doigt (312, 412).

4. Cellule solaire selon l'une quelconque des revendications 1 à 3, dans laquelle l'électrode de bord respective (113, 313) a une largeur dans la seconde direction supérieure ou égale à une largeur d'une électrode en forme de doigt respective (310, 410) dans la seconde direction.

5. Cellule solaire selon la revendication 4, dans laquelle l'électrode de bord respective (113, 313) a une largeur dans la seconde direction allant de 10µm à 55µm.

6. Cellule solaire selon l'une quelconque des revendications 1 à 5, dans laquelle l'électrode de bord respective (113, 313) est espacée de l'électrode en forme de doigt adjacente (311, 411) d'un premier pas, et le premier pas est inférieur ou égal à une distance entre une première électrode en forme de doigt respective (311, 411) et une seconde électrode en forme de doigt adjacente (312, 412).

7. Cellule solaire selon la revendication 6, dans laquelle le premier pas va de 0,2 mm à 0,7 mm.

8. Cellule solaire selon la revendication 6, dans laquelle la distance entre la première électrode en forme de doigt respective (311, 411) et la seconde électrode en forme de doigt adjacente (312, 412) va de 0,3 mm à 0,8 mm.

9. Cellule solaire selon l'une quelconque des revendications 1 à 8, dans laquelle l'électrode de bord respective (113, 313) et une électrode en forme de doigt respective (310, 410) comprennent un même matériau.

10. Cellule solaire selon l'une quelconque des revendications 1 à 9, dans laquelle ladite au moins une électrode de connexion (430) comprend un matériau identique à un matériau des électrodes en forme de doigt (310, 410), et dans la seconde direction, une électrode de connexion respective de ladite au moins une électrode de connexion (430) a une largeur supérieure ou égale à une largeur d'une électrode en forme de doigt respective des électrodes en forme de doigt.

11. Module photovoltaïque, comprenant :
au moins une chaîne de cellules formée chacune en connectant une pluralité de cellules solaires, dans lequel chaque cellule solaire est la cellule solaire selon l'une quelconque des revendications 1 à 10 ;
une pluralité d'éléments de connexion (409), dans lequel chaque élément de connexion (409) est configuré pour connecter électriquement la première barre omnibus principale (121, 321, 421) d'une cellule solaire de deux cellules solaires adjacentes avec la seconde barre omnibus principale (122, 322, 422) d'une autre cellule solaire des deux cellules solaires adjacentes ;
au moins un film adhésif d'encapsulation (17, 27, 47) configuré chacun pour couvrir une surface d'une chaîne de cellules respective ; et
au moins une plaque de couverture (48) configurée chacune pour couvrir une surface d'un film adhésif d'encapsulation respectif (17, 27, 47) faisant face à l'opposé de ladite au moins une chaîne de cellules.

12. Module photovoltaïque selon la revendication 11, comprenant en outre au moins un fil de connexion électrique, dans lequel la première électrode de bord (1131, 3131) est en contact électrique avec les ni premières barres omnibus principales (121, 321, 421) d'une cellule solaire de deux cellules solaires adjacentes, et un fil de connexion électrique respectif est connecté électriquement avec ladite une électrode de bord (113, 313), de sorte que le fil de connexion électrique respectif est connecté électriquement avec des secondes barres omnibus principales (122, 322, 422) de l'autre cellule solaire des deux cellules solaires adjacentes ; et/ou la seconde électrode de bord (1132, 3132) est en contact électrique avec les n₂ secondes barres omnibus principales (122, 322, 422) de ladite une cellule solaire des deux cellules solaires adjacentes, et le fil de connexion électrique respectif est connecté électriquement avec l'autre électrode de bord (113, 313), de sorte que le fil de connexion électrique respectif est connecté électriquement avec des premières barres omnibus principales (121, 321, 421) de l'autre cellule solaire des deux cellules solaires adjacentes.
